(19) Europäisches Patentamt
European Patent Office
Office européen des brevets

(11) Veröffentlichungsnummer: **0 138 768**
**B1**

(12) # EUROPÄISCHE PATENTSCHRIFT

(45) Veröffentlichungstag der Patentschrift: **28.02.90**

(51) Int. Cl.$^5$: **G 03 F 7/038**

(21) Anmeldenummer: **84810488.1**

(22) Anmeldetag: **08.10.84**

(54) **Strahlungsempfindliche Polykondensate, Verfahren zu deren Herstellung, beschichtetes Material und dessen Verwendung.**

(30) Priorität: **12.10.83 CH 5570/83**

(43) Veröffentlichungstag der Anmeldung: **24.04.85 Patentblatt 85/17**

(45) Bekanntmachung des Hinweises auf die Patenterteilung: **28.02.90 Patentblatt 90/09**

(84) Bennante Vertragsstaaten: **BE CH DE FR GB IT LI NL SE**

(56) Entgegenhaltungen: **EP-A-0 020 773**

(73) Patentinhaber: **CIBA-GEIGY AG**
**Klybeckstrasse 141**
**CH-4002 Basel (CH)**

(72) Erfinder: **Pfeifer, Josef, Dr.**
**Brunnmattstrasse 32**
**CH-4106 Therwil (CH)**

**EP 0 138 768 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBERGRAF, STOCKHOLM 1990

**Beschreibung**

Die vorliegende Erfindung betrifft strahlungsempfindliche lineare gesättigte Homo- und Copolykondensate aus der Gruppe der Polyester, Polyamide, Polyesteramide, Polyesterimide und Polyesteramidimide mit Benzophenondi-und/oder-tricarbonsäureresten, ein mit diesen Polykondensaten beschichtetes Material und dessen Verwendung zur Herstellung von Schutzüberzügen oder photographischen Abbildungen.

Aus der US-PS-3 926 639 ist es bekannt, dass Polymere, die Reste von Benzophenoncarbonsäuren enthalten, autophotopolymerisierbar sind oder als Photoinitiatoren für photopolymerisierbare Verbindungen geeignet sind. Es werden auch allgemein Polyester und Polyamide erwähnt. Als photopolymerisierbare Gruppen enthalten diese Polyester und Polyamide Reste von äthylenisch ungesättigten Carbonsäuren oder Alkoholen. Ferner sind in den Beispielen gesättigte und vernetzte Polyester beschrieben, die aus tri- und tetrafunktionellen Carbonsäuren und Alkoholen im Gemisch mit Dicarbonsäuren und Diolen erhalten werden. Bei diesen Polyestern handelt es sich um weiche und klebrige Materialien. Solche Materialien sind schwierig zu handhaben und ihre thermomechanischen Eigenschaften genügen nicht Anforderungen in verschiedenen Anwendungsbereichen, die an solche Materialien gestellt werden. Gegenstand vorliegender Erfindung sind strahlungsempfindliche lineare gesättigte Homo- und Copolykondensate aus der Gruppe der Polyester, Polyesteramide, Polyamide, Polyesterimide und Polyamidimide mit Benzophenondi-oder-tricarbonsäureresten mit mindestens einem der wiederkehrenden Strukturelemente der Formeln I und/oder II

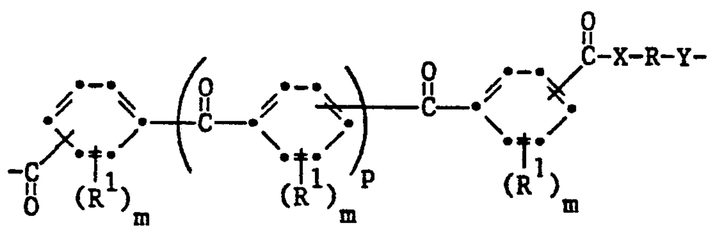

(I)

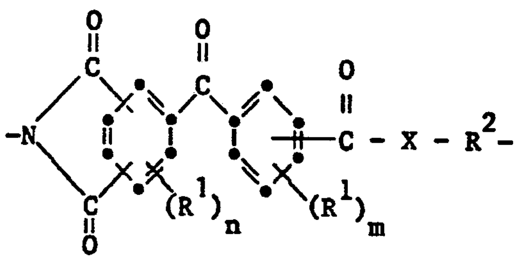

(II)

und im Falle von Copolykondensaten zusätzlich wiederkehrenden Strukturelementen der Formeln III und/oder IV

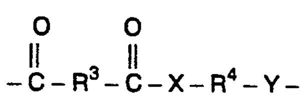

(III)

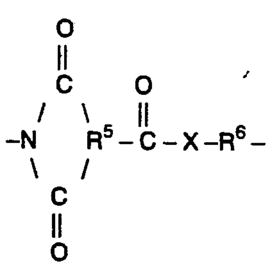

(IV)

worin die Imidgruppe im Strukturelement II an zwei benachbarte C-Atome gebunden ist, m für 0 oder eine Zahl von 1 bis 4 steht, p für eine Zahl von 1 bis 5 oder 0 steht und n für O oder eine Zahl von 1 bis 3 steht, X für -S-, -O- oder $-NR^7-$ steht und Y unabhängig die gleiche Bedeutung wie X hat,

$R^1$ Alkyl oder Alkoxy mit weniger als 6 C-Atomen, Aryl mit 6 bis 10 C-Atomen, Aralkyl mit 7 bis 10 C-Atomen oder Halogen bedeutet,

R einen unsubstituierten oder substituierten zweiwertigen aliphatischen, cycloaliphatischen, araliphatischen oder aromatischen Rest bedeutet, und falls X und Y die Gruppe $-NR^7$ - sind, R und eines der $R^7$ zusammen Alkylen mit 5 bis 7 C-Atomen, an das die zweite $-NR^7$-Gruppe gebunden ist, oder R Methylen Aethylen oder Propylen und und die

beiden $R^7$ der $NR^7$-Gruppen zusammen Aethylen oder Propylen oder falls X oder Y -O- oder -S- und das andere $-NR^7$- sind, R und $R^7$ zusammen Alkylen mit 5 - 7 C-Atomen bedeuten,
$R^2$ einen unsubstituierten oder substituierten zweiwertigen aliphatischen oder aromatischen Kohlenwasserstoffrest bedeutet und falls X die $-NR^7$-Gruppe ist, $R^2$ und $R^7$ zusammen Alkylen mit 5 bis 7 C-Atomen bedeutet,
$R^4$ unabhängig die gleiche Bedeutung wie R und $R^6$ unabhängig die gleiche Bedeutung wie $R^2$ hat,
$R^3$ ein zweiwertiger gesättigter aliphatischer oder aromatischer Rest ist,
$R^5$ für einen dreiwertigen gesättigten aliphatischen oder aromatischen Rest steht,in dem die Imidgruppe an zwei benachbarte C-Atome gebunden ist, und
$R^7$ ein Wasserstoffatom, Alkyl, Cycloalkyl, Aryl, Aralkyl oder Alkaralkyl bedeutet,

wobei die Copolykondensate die Strukturelemente der Formeln I und/oder II zu mindestens 10 Mol.-% enthalten, bezogen auf das Copolykondensat.

In den Formeln I und III haben X und Y bevorzugt die gleiche Bedeutung und vorteilhaft stehen X und Y in den Formeln I - IV für eine $-NR^7$-Gruppe oder -O-. Besonders bevorzugt stehen in den Formeln I und III X und Y entweder für -O- oder für die $NR^7$-Gruppe. In den Formeln II und IV steht X bevorzugt für die $NR^7$-Gruppe.

Der Anteil der Strukturelemente der Formeln I und/oder II beträgt in den Polykondensaten bevorzugt mindestens 50 Mol.-%, besonders mindestens 70 Mol.-% und insbesondere mindestens 90 Mol.-%. Der Anteil richtet sich im wesentlichen nach der gewünschten Strahlungsempfindlichkeit der Polykondensate.

In den Formeln I und II stehen p, m und n bevorzugt für 1 und insbesondere für 0. $R^1$ ist bevorzugt Alkyl oder Alkoxy mit 1 bis 4 C-Atomen, besonders Methyl, Aethyl und Methoxy, oder Halogen, besonders Br oder Cl.

$R^7$ enthält als lineares oder verzweigtes Alkyl bevorzugt 1 bis 6 C-Atome, als Cycloalkyl 5 bis 7 Ringkohlenstoffatome und kann Cyclopentyl, Cyclohexyl oder Methylcyclohexyl sein. $R^7$ als Arylreste sind besonders Phenylreste, z. B. Phenyl, Methylphenyl oder Benzyl. Besonders bevorzugt ist $R^7$ ein Wasserstoffatom.

Die Carbonylgruppen in den Strukturelementen der Formeln I und II sind bevorzugt in Metastellung und besonders in Parastellung zur Carbonylbrückengruppe und die Imidgruppe in Formel II in Ortho-/Metastellung und besonders Meta-/Parastellung zur Carbonylbrückengruppe gebunden.

R, $R^2$, $R^4$ und $R^6$ in den Formeln I bis IV in der Bedeutung als zweiwertigeraliphatischer Rest enthält bevorzugt 2 bis 30C-Atome. Besonders enthält der Rest 6 bis 30 und insbesondere 6 bis 20 C-Atome, wenn X und Y die $NR^7$-Gruppe bedeuten. Wenn X und Y in den Formeln I und III für -S- oder -O- stehen, oder X in den Formeln II und IV für -O-, -S- oder die $-NR^7$-Gruppe steht,enthält der aliphatische Rest bevorzugt 2 bis 20 und besonders 2 bis 12 C-Atome. In einer bevorzugten Untergruppe sind R, $R^2$, $R^4$ und $R^6$ lineares oder verzweigtes Alkylen, das durch Sauerstoffatome, NH, $NR^a$ $^+NR^a_2G^-$, Cyclopentylen, Cyclohexylen, Napthylen, Phenylen oder Hydantoinreste unterbrochen sein kann. $R^a$ kann z. B. Alkyl mit 1 bis 12 C-Atomen oder Cycloalkyl mit 5 oder 6 Ring-C-Atomen, Phenyl oder Benzyl sein. $G^-$ bedeutet ein Anion einer Protonensäure, z. B. Halogenid, Sulfat, Phosphat. In einer weiteren bevorzugten Ausführungsform sind R, $R^2$, $R^4$ und $R^6$ lineares oder verzweigtes Alkylen, $-(CH_2)_x-R^8-(CH_2)_y-$, worin $R^8$ Phenylen, Naphthylen, Cyclopentylen oder Cyclohexylen und x und y unabhängig voneinander die Zahl 1, 2 oder 3 sind, $-R^9-(OR^{10})_p-O-R^9-$, worin $R^9$ Aethylen, 1,2-Propylen, 1,3-Propylen oder 2-Methyl-1,3-Propylen und $R^{10}$ Aethylen, 1,2-Propylen, 1,2-Butylen, 1,3-Propylen oder 1,4-Butylen und p eine Zahl von 1 bis 100 sind, oder

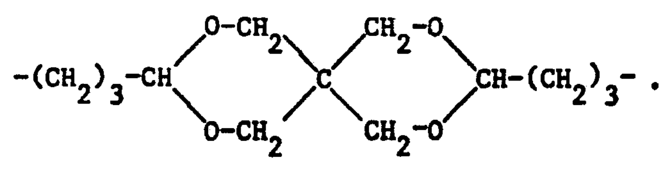

Beispiele für aliphatische Reste sind: Aethylen, 1,2- oder 1,3-Propylen, 2,2-Dimethyl-1,3-propylen, 1,2-, 1,3- oder 1,4-Butylen, 1,3- oder 1,5-Pentylen, Hexylene, Heptylene, Octylene, Decylene, Dodecylene, Tetradecylene, Hexadecylene, Octadecylene, Eicosylene, 2,4,4-Trimethylhexylen, 1,10-Dialkyldecylen, wobei das Alkyl bevorzugt 1 bis 6 C-Atome aufweist, substituierte 1,11-Undecylene, wie sie z. B. in der EP-B-0 011 559 beschrieben sind, zweiwertige Reste von Jeffaminen wie z. B.

$-(CH_2)_3-(-OCHCH_2-)_p-O-(-CH_2-)_3-$ mit p = 1 bis 100 oder
$\qquad\quad |$
$\qquad\quad CH_3$

$-(CH_2-)_3-(-O(CH_2)_4-)_p-O-(-CH_2)_3-$ mit p = 1 - 100, Dimethylencyclohexan,

Xylylen und Diäthylenbenzol. Besonders bevorzugt sind R, $R^2$, $R^4$ und $R^6$ längerkettiges, verzweigtes Alkylen mit z. B. 8 bis 30 C-Atomen, wenn X und Y in den Formeln I bis IV für die $-NR^7$-Gruppen stehen.

Wenn X und Y in den Formeln I bis IV, besonders in den Formeln I und III, für -O- oder -S- stehen, sind R, $R^2$, $R^4$ und $R^6$ bzw. R und $R^4$ bevorzugt lineares Alkyl mit 2 bis 12, besonders 2 bis 6 C-Atomen.

Bei den durch heterocyclische Reste unterbrochenen aliphatischen Resten kann es sich z. B. um solche

handeln, die sich von N,N'-aminoalkylierten bzw. N,N'-hydroxyalkylierten Hydantoinen oder Benzimidazolen ableiten. Beispiele sind N,N'-(γ-Aminopropyl)-5,5-dimethyl-hydantoin oder -benzimidazolon und solche der Formel

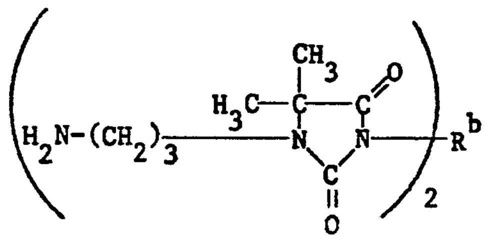

worin $R^b$ Alkylen mit 1 bis 12, bevorzugt 1 bis 4 C-Atomen oder $-(CH_2\underset{\underset{R^c}{|}}{C}HO)_aCH_2CH_2$ ist, worin $R^c$ ein Wasserstoffatom oder Methyl und a ganze Zahlen von 1 - 20 bedeuten.

Beispiele für entsprechende Diole sind N,N'-(ß-hydroxyäthyl)-5,5-dimethylhydantoin, N,N'-(ß-hydroxyäthyl)benzimidazolon und N,N'-ß-hydroxyäthyl)-4,5,6,7-tetrabrombenzimidazolon.

Geeignete Substituenten für die aliphatischen Reste sind z. B. Halogene wie F oder Cl und Alkyl oder Alkoxy mit 1 bis 6 C-Atomen.

R, $R^2$, $R^4$ und $R^6$ in den Formeln I bis IV in ihrer Bedeutung als zweiwertiger cycloaliphatischer Rest enthalten bevorzugt 5 bis 8 Ring-C-Atome und sind besonders unsubstituiertes oder mit Alkyl, das vorzugsweise 1 bis 4 C-Atome enthält, substituiertes ein- oder zweikerniges Cycloalkylen mit 5 bis 7 Ring-C-Atomen. In einer bevorzugten Ausführungsform sind R, $R^2$, $R^4$ und $R^6$ als cycloaliphatische Reste solche der Formeln

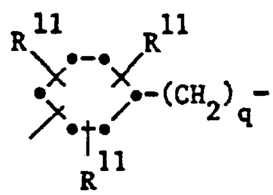

oder

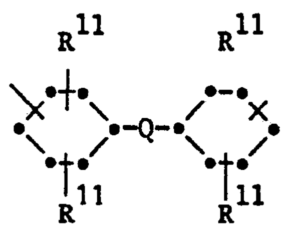

worin q 0 oder 1 ist, die $R^{11}$ unabhängig Wasserstoff oder Alkyl mit 1 bis 6 C-Atomen bedeuten und Q für eine direkte Bindung, O, S, $SO_2$, Alkylen mit 1 bis 3 C-Atomen oder Alkyliden mit 2 bis 6 C-Atomen steht. $R^{11}$ ist bevorzugt Aethyl und Methyl, Q bevorzugt Methylen und das Alkyliden enthält bevorzugt 2 oder 3 C-Atome, wie Aethyliden und 1,1- oder 2,2-Propyliden.

Beispiele für R, $R^2$, $R^4$ und $R^6$ als Cycloalkylen sind: 1,2- oder 1,3-Cyclopentylen, 1,2-, 1,3- oder 1,4-Cyclohexylen, Cycloheptylen, Cyclooctylen, Methylcyclopentylen, Methyl- oder Dimethylcyclohexylen, 3- oder 4-Methylcyclohex-1-yl, 5-Methyl-3-methylencyclohex-1-yl, 3,3'- oder 4,4'-Bis-cyclohexylen, 3,3'-Dimethyl-4,4'-biscyclohexylen, 4,4'-Biscyclohexylenäther oder -sulfon oder -methan oder -2,2-propan, sowie die zweiwertigen Reste von Bisaminomethyltricyclodecan, Bis-aminomethylnorbornan und Menthandiamin. Besonders bevorzugt als zweiwertiger cycloaliphatischer Rest ist 1,4- oder 1,3-Cyclohexylen, Methylenbis(cyclohex-4-yl) oder Methylenbis(3-methyl-cyclohex-4-yl).

R, $R^2$, $R^4$ und $R^6$ als araliphatische Reste enthalten bevorzugt 7 bis 30 C-Atome. Sofern die aromatische Gruppe des araliphatischen Restes an N-Atome im Rest der Formel I bis IV gebunden sind, was bevorzugt ist, so sind diese aromatischen Gruppen bevorzugt so substituiert wie R, $R^2$, $R^4$ und $R^6$ als aromatischer Rest, einschliesslich der Bevorzugungen. Der araliphatische Rest enthält bevorzugt 7 bis 26, besonders 8 bis 22 C-Atome. Der aromatische Rest im araliphatischen Rest ist bevorzugt ein Phenylrest. In ihrer Bedeutung als araliphatischer Rest sind R, $R^2$, $R^4$ und $R^6$ besonders unsubstituiertes oder am Aryl durch Alkyl substituiertes Aralkylen, wobei der Alkylenrest linear oder verzweigt ist. In einer bevorzugten Ausführungsform entspricht der araliphatische Rest der Formel

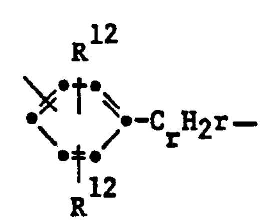

worin die $R^{12}$ unabhängig voneinander ein Wasserstoffatom oder besonders Alkyl mit 1 - 6 C-Atomen und r ganze Zahlen von 1 - 20 bedeuten. Die freie Bindung kann sich in o-Stellung, m-Stellung und besonders in p-Stellung zur $C_rH_{2r}$-Gruppe befinden und eine oder beide $R^{12}$ sind bevorzugt in o-Stellung zur freien Bindung gebunden. Für X und Y in der Bedeutung von -O- oder -S- ist der araliphatische Rest bevorzugt substituiert.

Beispiele für R, $R^2$, $R^4$ und $R^6$ als zweiwertiger araliphatischer Rest sind: m- oder p-Benzylen, 3-Methyl-p-benzylen, 3-Aethyl-p-benzylen, 3,5-Dimethyl-p-benzylen, 3,5-Diäthyl-p-benzylen, 3-Methyl-5-äthyl-p-benzylen, p-Phenylenpropylen, 3-Methyl-p-phenylen-propylen, p-Phenylenbutylen, 3-Aethyl-p-phenylenpentylen sowie insbesondere längerkettige Phenylenalkylenreste von Diaminen, die z. B. in der EP-A-0 069 062 beschrieben sind: 6-(p-Phenylen)-6-methylhept-2-yl, 6-(3'-Methyl-p-phenylen)-6-methylhept-2-yl, 6-(3'-Aethyl-p-phenylen)-6-methylhept-2-yl, 6-(3',5'-Dimethyl-p-phenylen)-6-methylhept-2-yl, 11-(p-Phenylen)-2,11-dimethyl-dodec-1-yl, 13-(p-Phenylen)-2,12-dimethyltetradec-3-yl.

Unter den Homo- und Copolykondensaten sind besonders solche mit Strukturelementen der Formel I bis IV bevorzugt, in der R, $R^2$, $R^4$ und $R^6$ unsubstituierte und besonders substituierte aromatische Reste bedeuten und X und Y die -$NR^7$-Gruppe sind. Der Substituent am aromatischen Rest enthält bevorzugt 1 bis 20, besonders 1 - 12 und insbesondere 1 - 6 C-Atome. Insbesondere ist der Substituent lineares oder verzweigtes Alkyl, Alkoxy oder Alkoxyalkyl mit 1 bis 6 C-Atomen, Benzyl, Trimethylen oder Tetramethylen. Als Alkoxyalkyl ist Alkoxymethyl bevorzugt und als Alkoxy Methoxy. Beispiele für den Substituenten sind: Methyl, Aethyl, Propyl, Isopropyl, n-Butyl, Isobutyl, Pentyl, Hexyl, Octyl, Dodecyl, Tetradecyl, Eicosyl, Methoxy, Aethoxy, Propoxy, Butoxy, Pentoxy, Hexoxy, Methoxymethyl, Methoxyäthyl, Aethoxymethyl, Propoxymethyl, Butoxymethyl, Benzyl, Methylbenzyl und Phenyläthyl. Bevorzugte Reste sind Methoxymethyl, Aethoxymethyl, Methyl, Aethyl, Trimethylen und Tetramethylen. Besonders bevorzugt ist Methyl und Aethyl. Bei dem aromatischen Rest kann es sich um einkernige oder mehrkernige, besonders zweikernige Reste handeln. Einkernige Reste können 1 bis 4, bevorzugt 2 bis 4 und besonders 4 Substituenten enthalten und zweikernige Reste können 1 bis 4, bevorzugt 2 Substituenten in jedem Kern enthalten. Es wurde gefunden, dass die Lichtempfindlichkeit von Homo- oder Copolykondensaten besonders hoch ist, wenn ein und besonders zwei Substituenten in Orthostellung zur X- bzw. Y-Gruppe gebunden sind und X und Y -$NR^7$-sind. Ferner weisen solche Polykondensate besonders gute thermomechanische Eigenschaften auf. Die Substitution in einer oder beiden Orthostellungen ist daher in diesem Fall bevorzugt. Der aromatische Rest ist bevorzugt in Meta- oder Parastellung zur X- bzw. Y-Gruppe gebunden. Falls X und Y für -O- oder -S- stehen, sind unsubstituierte zweikernige aromatische Reste bevorzugt.

R bzw. R' kann als aromatischer Rest 6 bis 30, besonders 6 bis 20 C-Atome enthalten. Der aromatische Rest ist bevorzugt ein Kohlenwasserstoffrest, besonders ein ein- oder zweikerniger Phenylenrest, ein Naphthylenrest oder ein Pyridinrest, der durch Alkyl, Alkoxyalkyl, Alkoxy, Trimethylen oder Tetramethylen substituiert ist.

Eine bevorzugte Untergruppe sind solche aromatische Reste der Formeln

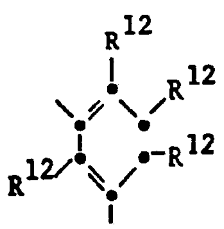 , 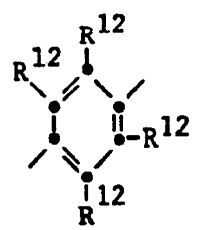 , 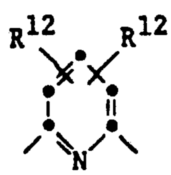 ,

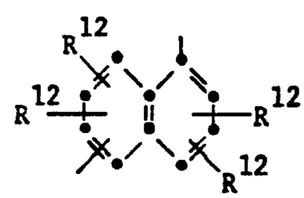 , 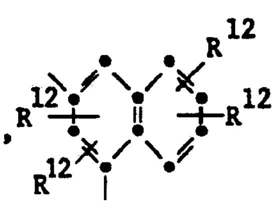 , 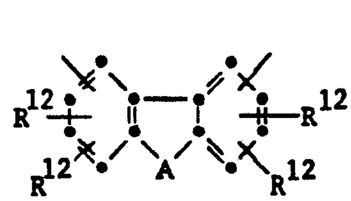

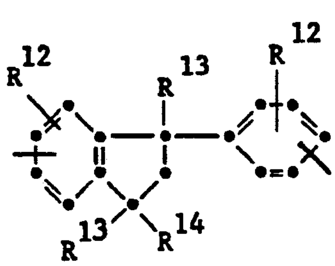 oder

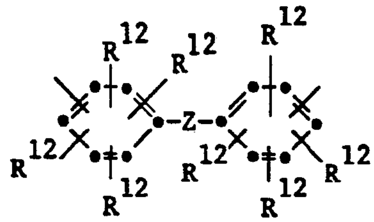,

worin alle R ein Wasserstoffatom, $R^{12}$ im Falle der Monosubstitution Alkyl mit 1 bis 6 C-Atomen und die anderen $R^{12}$ Wasserstoffatome sind, und im Falle der Di-, Tri- oder Tetrasubstitution zwei $R^{12}$ Alkyl mit 1 bis 6 C-Atomen und die anderen $R^{12}$ ein Wasserstoffatom oder Alkyl mit 1 bis 6 C-Atomen sind oder im Falle der Di-, Tri- oder Tetrasubstitution zwei vicinale $R^{12}$ im Phenylring für Trimethylen oder Tetramethylen und die anderen $R^{12}$ für ein Wasserstoffatom oder Alkyl mit 1 bis 6 C-Atomen stehen, A für O, S, NH, CO oder $CH_2$ steht, $R^{13}$ ein Wasserstoffatom oder Alkyl mit 1 bis 5 C-Atomen und $R^{14}$ Alkyl mit je 1 bis 5 C-Atomen darstellt, und Z eine direkte Bindung, O, S, SO, $SO_2$,
O O
|| ||
CO, $CNR^{15}$, $NR^{15}$, CONH, NH, $R^{15}SiR^{16}$, $R^{15}OSiOR^{16}$, Alkylen mit 1 bis 6 C-Atomen, Alkenylen oder Alkyliden mit 2 bis 6 C-Atomen, Phenylen oder Phenyldioxyl bedeutet, worin $R^{15}$ und $R^{16}$ unabhängig voneinander Alkyl mit 1 bis 6 C-Atomen oder Phenyl bedeuten. $R^{13}$ und $R^{14}$ sind bevorzugt Methyl, A steht bevorzugt für $-CH_2-$ oder -O- und Z bevorzugt für eine direkte Bindung, -O-, $-CH_2-$ oder Alkyliden mit 2 bis 4 C-Atomen. $R^{15}$ und $R^{16}$ stehen besonders für Methyl, Aethyl und Phenyl. Das Alkylen enthält bevorzugt 2 bis 4 C-Atome und ist besonders Aethylen. Alkenylen ist besonders Aethenylen.

Eine bevorzugte Untergruppe sind Toluylenreste, Reste o,o'-substituierter Diaminodiphenylene, Diaminodiphenylmethane und Diaminodiphenyläther.

Eine besonders bevorzugte Gruppe sind solche aromatischen Reste der Formeln

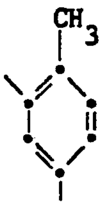, 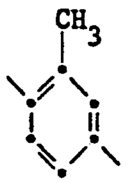, 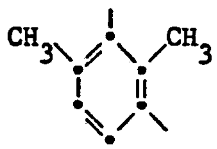, 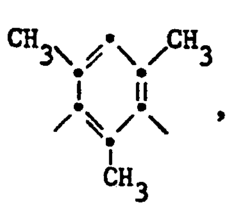, 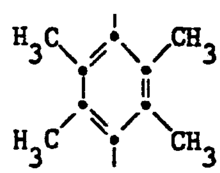,

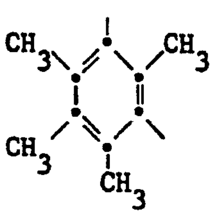 oder 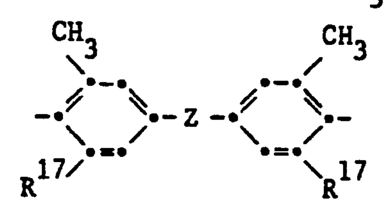

worin Z eine direkte Bindung, O und besonders $CH_2$ bedeutet und $R^{17}$ ein Wasserstoffatom und besonders Methyl oder Äthyl darstellt.

Beispiele für unsubstituierte und substituierte aromatische Reste sind 1,3- oder 1,4-Phenylen, 2,4- oder 2,7-Naphthylen, 4,4'-Diphenylen, 4,4'-Diphenylenmethan, 4,4'-Diphenylenäther, 4-Methyl-1,3-phenylen, 4-Aethyl-1,3-phenylen, 2-Methyl-1,3-phenylen, 4-Benzyl-1,3-phenylen, 4-Methoxymethyl-1,3-phenylen, Tetrahydro-1,3- oder -1,4-naphthylen, 3-Propyl-1,3- oder -1,4-phenylen, 3-Isopropyl-1,4-phenylen, 3,5-Dimethyl-1,4-phenylen, 2,4-Dimethyl-1,3-phenylen, 2,3-Dimethyl-1,4-phenylen, 5-Methyl-1,3-phenylen, 2,3,5,6-Tetramethyl-1,4- oder -1,3-phenylen, 3-Methyl-2,6-pyridylen, 3,5-Dimethyl-2,6-pyridylen, 3-Äthyl-2,6-pyridylen, 1-Methyl-2,7-naphthylen, 1,6-Dimethyl-2,7-naphthylen, 1-Methyl-2,4-naphthylen, 1,3-Dimethyl-2,4-naphthylen, die zweiwertigen Reste von 5-Amino-1-(3'-amino-4'-methylphenyl)-1,3,3-trimethylindan oder 6-Amino-5-methyl-1-(3'-amino-4'-methyl)-1,3,3-trimethylindan, 4-Methoxymethyl-1,3-phenylen, 3-Methyl-p-diphenylen, 3-Äthyl-p-diphenylen, 3,3'-Dimethyl-p-diphenylen, 3,3'-Diäthyl-p-diphenylen, 3-Methyl-3'-äthyl-p-diphenylen, 3,3',5,5'-Tetramethyl-diphenylen, 3,3'-Methyl-5,5'-äthyl-p-diphenylen, 4,4'-Dimethyl-m-diphenylen, 3,3'-Diisopropyl-diphenylen, Reste der Formeln

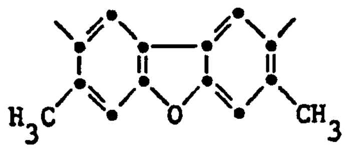 , 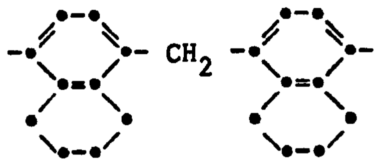 ,

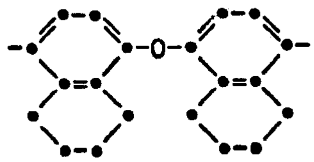 , 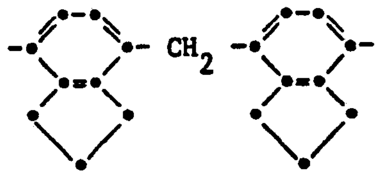 ,

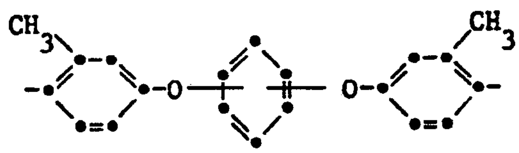

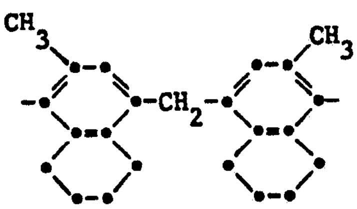 , 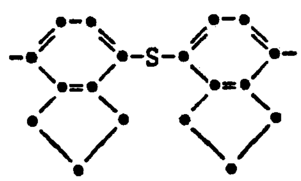 ,

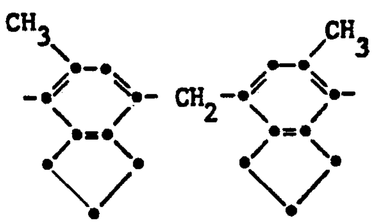 , 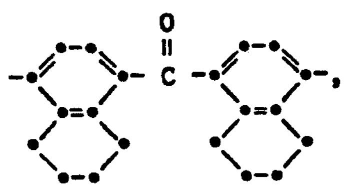 ,

sowie

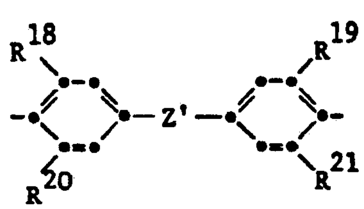 , 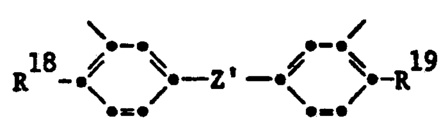

und 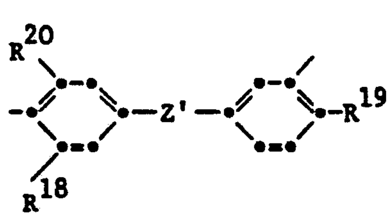

worin Z; $R^{18}$, $R^{19}$, $R^{20}$ und $R^{21}$ die in nachfolgender Tabelle angegebenen Bedeutungen haben:

| Z' | $R^{18}$ | $R^{19}$ | $R^{20}$ | R21 |
|---|---|---|---|---|
| $CH_2$ | Methyl | Methyl | - | - |
| $CH_2$ | Methyl | Aethyl | - | - |
| $CH_2$ | Aethyl | Aethyl | - | - |
| $CH_2$ | Isopropyl | Isopropyl | - | - |
| $CH_2$ | Methoxymethyl | | - | - |
| $CH_2$ | Benzyl | Benzyl | - | - |
| $CH_2$ | Methyl | Methyl | H | H |
| $CH_2$ | Aethyl | Aethyl | H | H |
| $CH_2$ | Isopropyl | Isopropyl | H | H |
| $CH_2$ | Methoxymethyl | | H | H |
| $CH_2$ | Methyl | Aethyl | H | H |
| $CH_2$ | Methoxymethyl | | Methoxymethyl | |
| $CH_2$ | Methyl | Methyl | Methyl | Methyl |
| $CH_2$ | Aethyl | Aethyl | Aethyl | Aethyl |
| $CH_2$ | Methyl | Methyl | Aethyl | Aethyl |
| $CH_2$ | Aethyl | Aethyl | Isopropyl | Isopropyl |
| $CH_2$ | Isopropyl | Isopropyl | Isopropyl | Isopropyl |
| $CH_2$ | Isopropyl | Isopropyl | H | H |
| $CH_2$ | Methoxy | Methoxy | H | H |
| O | Methyl | Methyl | - | - |
| O | Aethyl | Aethyl | - | - |
| O | Methyl | Methyl | H | H |
| O | Methyl | Methyl | Methyl | Methyl |
| O | Methyl | Methyl | Aethyl | Aethyl |
| S | Methyl | Methyl | - | - |
| S | Aethyl | Aethyl | - | - |
| S | Methyl | Methyl | H | H |
| S | Methyl | Methyl | Methyl | Methyl |
| S | Aethyl | Aethyl | Aethyl | Aethyl |
| S | Methyl | Methyl | Aethyl | Aethyl |
| CO | Methyl | Methyl | - | - |
| CO | Methyl | Methyl | H | H |
| CO | Methyl | Methyl | Methyl | Methyl |
| $SO_2$ | Methyl | Methyl | - | - |
| $SO_2$ | Methyl | Methyl | H | H |
| $SO_2$ | Methyl | Methyl | Methyl | Methyl |
| $SO_2$ | Aethyl | Aethyl | Methyl | Methyl |
| SO | Methyl | Methyl | - | - |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | - | - |
| $NCH_3$ | Methyl | Methyl | Methyl | Methyl |
| CONH | Methyl | Methyl | - | - |
| NH | Aethyl | Aethyl | H | H |
| NH | Methyl | Methyl | - | - |
| $Si(Methyl)_2$ | Methyl | Methyl | - | - |
| $Si(Phenyl)_2$ | Methyl | Methyl | Methyl | Methyl |
| $Si(OMethyl)_2$ | Aethyl | Aethyl | - | - |
| $Si(OPhenyl)_2$ | Methyl | Methyl | H | H |
| Aethylen | Methyl | Methyl | - | - |
| Aethylen | Methyl | Methyl | Methyl | Methyl |
| Aethylen | Aethyl | Aethyl | H | H |
| Aethylen | Methyl | Methyl | - | - |
| Phenylen | H | H | Methyl | Methyl |
| Phenylen | Alkyl | Alkyl | - | - |
| $(CH_3)_2C<$ | Methyl | Methyl | H | H |
| $(CH_3)_2C<$ | Methyl | Methyl | Methyl | Methyl |

Falls X und Y in den Formeln I und III die $NR^7$-Gruppe oder X bzw. Y -O- oder -S- und das andere die $NR^7$-Gruppe bedeuten oder X in den Formeln II und IV ein Sauerstoffatom sind, kann R und eines der $R^7$ bzw. $R^2$ und $R^7$ zusammen Alkylen mit 5 - 7 C-Atomen sein, an das die zweite -$NR^7$-Gruppe bzw. -O- oder -S- gebunden ist, oder R bzw. $R^2$ sind Methylen, Aethylen oder Propylen und die beiden $R^7$ der $NR^7$-Gruppen zusammen sind Aethylen oder Propylen. Die so definierten Reste leiten sich von heterocyclischen Diaminen oder Aminoalkoholen bzw. -thiolen ab. Beispiele hierfür sind: 3-Aminopyrrolidin, 3-Hydroxypyrrolidin, Imidazolidin, 3- oder 4-Aminopiperidin, 3- oder 4-Hydroxypiperidin und Piperazin. Eine bevorzugte Gruppe von Polykondensaten sind solche, in denen X und Y in den Formeln I bis IV für die -$NR^7$-Gruppe stehen und R, $R^2$, $R^4$ und $R^6$ einen Rest der Formeln

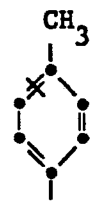 , 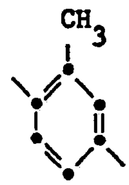 , 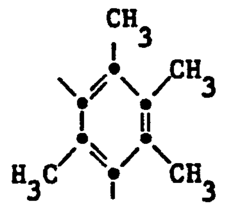 , 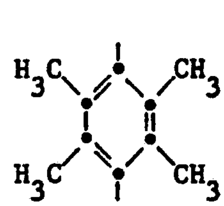

oder 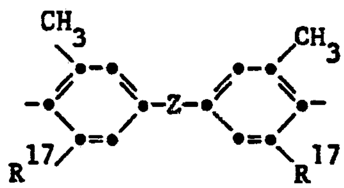

sind, worin Z eine direkte Bindung, -O- und besonders $-CH_2-$ bedeutet und $R^{17}$ Aethyl oder besonders Methyl ist, oder verzweigtes Alkylen mit 6 bis 20 C-Atomen, das besonders in α-Stellung zur -$NR^7$-Gruppe verzweigt ist.

Wenn X und Y in den Formeln I und III ein Sauerstoffatom bedeuten, ist in einer bevorzugten Ausführungsform R bzw. $R^4$ verzweigtes und besonders lineares Alkylen mit 2 bis 20, besonders 2 bis 12 C-Atomen, der zweiwertige Rest eines Polyoxyalkylenes mit 2 - 100 Oxaalkyleneinheiten, z. B. $-(-OCH_2CH_2O-)_u-$ oder $-(-OCHCH_2O-)_u-$ oder $-(-OCH_2CH_2CH_2O-)_u-$ mit u = 2 bis 100, Cyclohexylen,
|
$CH_3$

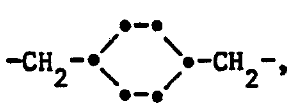 Benzylen, oder ein- oder zweikerniger Phenylenrest der Formeln

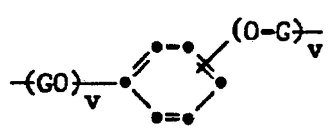 oder 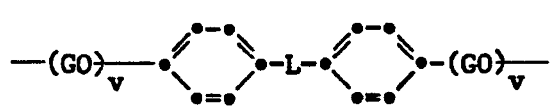

worin v 0 oder 1 ist, L eine direkte Bindung, -O-, -S-, -SO-, $-S_2-$, CO, Methylen, Aethyliden, 1,1- oder 2,2-propyliden, Butyliden oder Cyclohexyliden ist und G für Aethylen, 1,2-Propylen oder 2-Hydroxy-1,3-propylen steht. Die Phenylenreste können durch Alkyl oder Alkoxy mit 1 bis 4 C-Atomen oder Halogen, besonders C1 und Br, substituiert sein.

$R^3$ ist der zweiwertige Rest einer gesättigten organischen Dicarbonsäure. Der aliphatische Rest kann 2 bis 40, bevorzugt 2 bis 20 C-Atome und besonders 2 - 12 C-Atome enthalten. $R^3$ kann z. B. ein cycloaliphatischer Rest mit 5 bis 7 Ringkohlenstoffatomen oder lineares oder verzweigtes Alkylen mit 2 bis 12 C-Atomen sein. Als aromatischer Rest enthält $R^3$ bevorzugt 6 - 18 C-Atome und ist bevorzugt ein aromatischer Kohlenwasserstoffrest.

Als aliphatische Dicarbonsäuren kommen jene mit 2 bis 40 C-Atome in Frage, z. B. Oxalsäure, Malonsäure, Dimethylmalonsäure, Bernsteinsäure, Pimelinsäure, Adipinsäure, Trimethyladipinsäure, Sebacinsäure, Azelainsäure und hydrierte Dimersäuren (Dimerisationsprodukte von ungesättigten aliphatischen Carbonsäuren wie Oelsäure), alkylierte Malon- und Bernsteinsäuren wie Octadecylbernsteinsäure.

Als cycloaliphatische Dicarbonsäuren kommen in Frage:
1,3-Cyclobutandicarbonsäure, 1,3-Cyclopentandicarbonsäure, 1,3- und 1,4-Cyclohexandicarbonsäure, 1,3- und 1,4-(Dicarboxylmethyl)-cyclohexan, 4,4'-Dicyclohexyldicarbonsäure.

Als geeignete aromatische Dicarbonsäuren kommen in Frage:
Terephthalsäure, Isophthalsäure, o-Phthalsäure, 1,3-, 1,4-, 2,6- oder 2,7-Naphthalindicarbonsäure, 4,4'-Diphenyl-dicarbonsäure, 4,4'-Diphenylsulfoncarbonsäure, 1,1,3-Trimethyl-5-carboxyl-3-(p-carboxylphenyl)-indan, 4,4'-Diphenylätherdicarbonsäure, Bis-p-(carboxylphenyl)methan, Tetrabromterephthalsäure.

Aromatische und cycloaliphatische Orthodicarbonsäuren sowie Glutarsäuren und Bernsteinsäuren sind für Polyamide weniger geeignet, da sie unter dem Einfluss von primären Aminen zur Bildung von Imiden neigen. Bevorzugt sind die aromatischen Dicarbonsäuren, unter ihnen besonders Terephthalsäure und Isophthalsäure.

$R^5$ ist der dreiwertige Rest einer gesättigten aliphatischen, oder aromatischen Tricarbonsäure, in der zwei Carboxylgruppen an zwei benachbarte C-Atome gebunden sind. Der dreiwertige Rest kann 2 bis 16 C-Atome enthalten. Bevorzugt ist $R^5$ ein aromatischer Rest. Beispiele für Tricarbonsäuren mit aliphatischem Rest sind Aethylentricarbonsäure und 1,3,4-Tricarboxycyclohexan. Beispiele für aromatische Reste sind besonders Trimellitsäure sowie 2,6,7-Naphthalintricarbonsäure, 3,4,4'-Diphenyltricarbonsäure, 3',3,4-Diphenyloxidtricarbonsäure, 3,4,4'-Diphenylmethantricarbonsäure und 3,4,4'-Diphenylsulfontricarbonsäure.

In einer besonders bevorzugten Ausführungsform enthalten die erfindungsgemässen Polykondensate Strukturelemente der Formeln

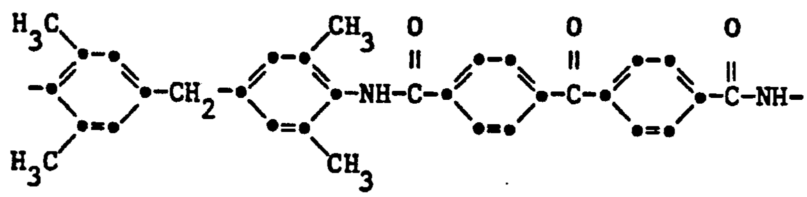 oder

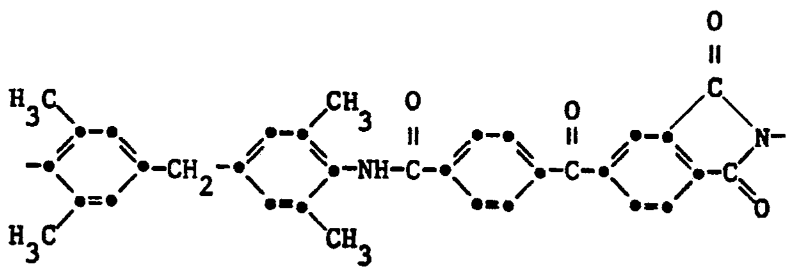 oder

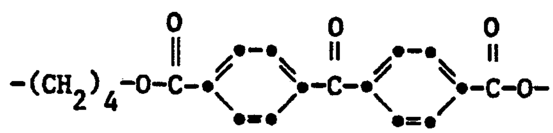

Die erfindungsgemässen Polykondensate können mittlere Molekulargewichte (Gewichtsmittel $\overline{M}w$ ) von mindestens 2 000, vorzugsweise mindestens 5 000 aufweisen. Die obere Grenze richtet sich im wesentlichen nach den gewünschten Eigenschaften, wie zum Beispiel deren Verarbeitbarkeit oder deren Löslichkeit. Sie kann bis zu 500 000, vorzugsweise bis zu 100 000 und besonders bis zu 50 000 betragen. Es kann sich ferner um statistische Polymere oder um Blockpolymere handeln. Sie werden nach üblichen Verfahren in hierfür vorgesehenen Einrichtungen hergestellt. Die Polymeren sind vorzugsweise linear aufgebaut, können aber mit mindestens trifunktionellen Monomeren wie Triaminen, Triolen oder Tetrolen, die in kleinen Mengen zugesetzt werden, wenig verzweigt sein.

Ein weiterer Gegenstand ist ein Verfahren zur Herstellung der erfindungsgemässen Homo- und Kopolykondensate, das dadurch gekennzeichnet ist, dass man Benzophenondicarbonsäure der Formel V

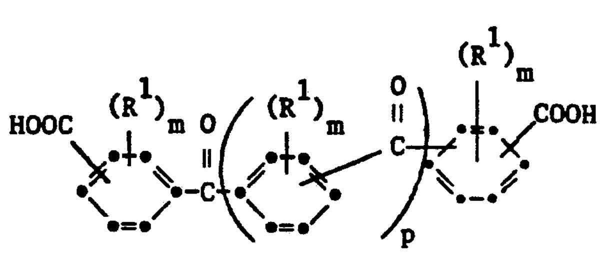 (V)

oder eine Benzophenontricarbonsäure der Formel VI

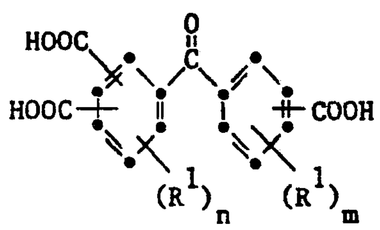

(VI)

oder Gemische dieser Säuren in einer Menge von mindestens 10 Mol.-%, bezogen auf das Polykondensat, gegebenenfalls zusammen mit einer Dicarbonsäure der Formel VII und/oder einer Tricarbonsäure der Formel VIII

$HOOC\text{-}R^3\text{-}COOH$ (VII)

HOOC<br>\\<br>$R^5$-COOH (VIII)<br>/<br>HOOC

oder deren Polyester- oder Polyamid bildenden Derivate mit einem Diol, Dimercaptan, einem Diamin, einem Aminoalkohol, einem Aminomerkapten, einem Hydroxymerkaptan der Formel IX oder mit Gemischen dieser Monomeren

HX - R - YH (IX),

worin m, n, $R^1$, $R^3$, $R^5$ und $R^7$ die angegebene Bedeutung haben und X und Y entweder für -O-, -S- oder für $-NR^7-$ oder X für -O-, -S- und Y für $-NR^7-$ stehen, polykondensiert.

Die Reaktanden der Formeln V bis IX sind bekannt, oder können nach bekannten Verfahren hergestellt werden. Geeignete Polyamid- bzw. Polyester bildende Derivate sind z. B. die Säureanhydride, Säureamide, Säurehalogenide und Säureester. Geeignete Herstellverfahren sind zum Beispiel die Lösungsmittelpolykondensation, die Schmelzkondensation und die Grenzflächenpolykondensation. Geeignete Lösungsmittel sind nachfolgend erwähnt. Homo- und Copolykondensate mit Imidgruppen können in 2 Stufen hergestellt werden, indem zunächst Vorstufen dieser Polykondensate mit Amidgruppen hergestellt werden, und die Amidgruppen in einer zweiten Stufe in die Imidgruppen überführt, was thermisch oder in Gegenwart wasserbindender Mittel wie Carbonsäureanhydriden erfolgen kann.

Die Reaktionstemperaturen richten sich im wesentlichen nach den Ausgangsmaterialien bzw. deren Reaktivität. Sie kann -50 bis 350°C, vorzugsweise 50 bis 300°C betragen. Ferner kann die Polykondensation bei Normaldruck oder Unterdruck durchgeführt werden. Vorteilhaft wird bei der Kondensation entstehendes Wasser, Alkohol oder Amin während des Verfahrens aus dem Reaktionsgemisch entfernt bzw. entstehende Halogenwasserstoffe, z. B. HCl oder HBr, durch Zugabe geeigneter Mittel wie tertiäre Amine oder Epoxide gebunden.

Bei der Herstellung von Polyestern wird vorteilhaft ebenfalls in zwei Stufen verfahren, indem man in einer ersten Stufe eine Veresterung bzw. Umesterung mit dem Diol oder Dimerkaptan durchführt und anschliessend die Polykondensation bevorzugt in der Schmelze unter Entfernung des gebildeten überschüssigen Diols bzw. Merkaptans fortsetzt, bis die gewünschte Viskosität erreicht ist.

Bei den erfindungsgemässen Polykondensaten handelt es sich um Polymere, die direkt durch Einwirkung von Strahlung vernetzt werden können. Sie eignen sich zur Herstellung von Formkörpern, Folien, Fasern und zur Beschichtung von Substraten, für den Oberflächenschutz oder zur Erzeugung von Reliefabbildungen, wobei durch Bestrahlung die Eigenschaften der Polykondensate modifiziert werden können. Ein Teil der erfindungsgemässen Polykondensate sind Thermoplaste, die nach den für diese Polymerklasse üblichen Verfahren verarbeitet werden können. Die hochschmelzenden insbesondere vollaromatischen Polykondensate werden bevorzugt aus Lösung verarbeitet.

Ein bevorzugter Anwendungsbereich ist die Verwendung zur Beschichtung von Oberflächen und die Herstellung von Reliefabbildungen auf solchen beschichteten Substraten, was ein weiterer Gegenstand vorliegender Erfindung ist. Es ist besonders vorteilhaft, dass zur Erzielung gewünschter Eigenschaften die erfindungsgemässen Polykondensate für bestimmte Anforderungen bei der Anwendung durch Auswahl unterschiedlicher Monomerer und/oder durch Abmischung verschiedener Polykondensate entsprechend eingestellt werden können.

Zur Herstellung des erfindungsgemässen beschichteten Materials löst man ein Polykondensat oder Gemische davon zweckmässig in einem geeigneten organischen Lösungsmittel, gegebenenfalls unter Erwärmung. Geeignete Lösungsmittel sind z. B. polare, aprotische Lösungsmittel, die alleine oder in Mischungen aus mindestens zwei Lösungsmittel verwendet werden können. Beispiele sind: Aether wie Dibutyläther, Tetrahydrofuran, Dioxan, Aethylenglykol, Dimethyläthylenglykol, Dimethyldiäthylenglykol, Diäthyldiäthylenglykol, Dimethyltriäthylenglykol, halogenierte Kohlenwasserstoffe wie Methylenchlorid, Chloroform, 1,2-Dichloräthan, 1,1,1-Trichloräthan, 1,1,2,2-Tetrachloräthan. Carbonsäureester und Lactone wie Essigsäureäthylester, Propionsäuremethylester, Benzoesäureäthylester, 2-Methoxyäthylacetat, γ-Butyrolacton, o-Valerolacton und Pivalolacton, Carbonsäureamide und Lactame wie Formamid, Acetamid, N-Methylformamid, N,N-Dimethylformamid, N,N-Diäthylformamid, N,N-Dimethylacetamid, N,N-Diäthylacetamid, γ-Butyrolactam, ε-Caprolactam, N-Methypyrrolidon, N-Acetylpyrrolidon, N-Methylcaprolactam, Tetramethylharnstoff, Hexamethylphosphorsäuretriamid, Sulfoxide wie Dimethylsulfoxid, Sulfone wie Dimethylsulfon, Diäthylsulfon, Trimethylensulfon, Tetramethylensulfon, Trimethylamin, Triäthylamin, N-Methylpyrrolidin, N-Methylpiperidin, N-Methylmorpholin, substituierte Benzole wie Chlorbenzol, Nitrobenzol, Phenole oder Kresol.

Ungelöste Anteile können durch Filtration, bevorzugt einer Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung. Die Lösungen sind lagerstabil.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente und Haftvermittler. Ferner können auch falls erwünscht zusätzlich Sensibilisatoren, wie z. B. Thioxanthonderivate oder Benzophenonderivate einverleibt werden, um die Lichtempflindlichkeit noch weiter zu erhöhen.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z. B. Kunststoffe, Metalle und Metallegierungen, Halbmetalle, Halbleiter, Glas, Keramik und andere anorganische Materialien wie z. B. $SiO_2$ und $Si_3N_4$ Danach wird das Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichtdicken bis zu ca 500 µm und mehr, bevorzugt von 0,5 bis 500 µm und besonders von 1 bis 50 µm aufweisen.

Die strahlungsempfindliche Schicht im erfindungsgemässen Material kann durch Einwirkung von Strahlung vernetzt werden.

Die Photostrukturierung bzw. Photovernetzung kann durch energiereiche Strahlung hervorgerufen werden, z. B. durch Licht insbesondere im UV-Bereich,durch Röntgenstrahlen, Laserlicht, Elektronenstrahlen usw. Das erfindungsgemässe Material eignet sich hervorragend zur Herstellung von Schutzfilmen, Passivierlacken, und als photographisches Aufzeichnungsmaterial für thermostabile Reliefabbildungen.

Ein weiterer Gegenstand der Erfindung ist diese Verwendung. Anwendungsgebiete sind z. B. Schutz-, Isolier- und Passivierlacke in der Elektrotechnik und Elektronik, Photomasken für die Elektronik, den Textildruck und das graphische Gewerbe, Aetzresiste zur Herstellung gedruckter Schaltungen und Druckplatten und integrierter Schaltkreise, Relais für die Herstellung von Röntgenmasken, als Lötstopplack, als Dielektrium für Mehrlagenschaltungen, als Strukturelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten.

Die photographische Erzeugung der Reliefstruktur erfolgt durch bildmässige Belichtung durch eine Photomaske, anschliessende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Ein weiterer Gegenstand der Erfindung ist ein solches Verfahren zum Aufbringen von Reliefstrukturen. Als Entwickler sind z. B. die zuvor erwähnten Lösungsmittel geeignet.

Die Polymerschicht des erfindungsgemässen Materials weist eine für viele Anwendungszwecke ausreichende und teilweise hohe Lichtempfindlichkeit auf und sie kann direkt photovernetzt werden. Die Schutzfilme und Reliefabbildungen zeichnen sich durch gute Haftfestigkeit und thermische, mechanische und chemische Widerstandsfähigkeit aus. Bei thermischen Nachbehandlungen wird nur ein geringer Schwund beobachtet. Ferner können Zusätze zur Erzeugung bzw. Steigerung der Lichtempfindlichkeit vermieden werden. Das Material ist lagerstabil, ist aber vor Lichteinwirkung zu schützen.

Die nachfolgenden Beispiele erläutern die Erfindung näher.

**Beispiel 1**

In einem zylindrischen Gefäss, das mit Rührer, Tropftrichter, Thermometer, Gaseinleitungsrohr und Gasableitungsrohr ausgestattet ist, werden 4,2417 g eines technischen Diamingemisches (bestehend aus 3,3'-Diäthyl-4,4'-diaminodiphenylmethan, 3-Aethyl-4,4'-diaminodiphenylmethan und 4,4'-Diaminodiphenylmethan mit einem Aequivalentgewicht von 116,5 g/Val) in 40 ml N-Methylpyrrolidon (NMP) gelöst und unter Stickstoff auf -15°C abgekühlt. Unter Rühren werden 5,588 g Benzophenon-4,4'-dicarbonsäurechlorid in fester Form zugesetzt. Nachdem sich die Substanz aufgelöst hat, wird die Kühlung entfernt und 4,5 Stunden weitergerührt, wobei die Innentemperatur allmählich auf Raumtemperatur ansteigt. Dann werden 4,0 g Triäthylamin zugetropft, um die bei der Reaktion entstandene HCl zu binden. Nach 2 Stunden wird die Polyamidlösung auf 500 ml Wasser gegossen und das Polyamid durch starkes Mischen in einem Haushaltmixer ausgefällt. Das Polyamid wird dann abfiltriert, gut mit Wasser gewaschen und bei 80°C im Vakuum getrocknet. Die reduzierte Viskosität ($\eta$ red.) bei 25°C, gemessen als 0,5 %-ige Lösung in m-Kresol beträgt 0,80 dl/g.

Die Glasumwandlungstemperatur Tg, gemessen durch Differential-Scanning-Calorimetrie (DSC) beträgt 226°C.

**Reliefbilderzeugung**

Auf einer einseitig Kupfer-kaschierten Kunststoffplatte wird ein ca. 1 - 2 μm dicker Polymerfilm erzeugt, indem eine 5 %-ige Polyamidlösung aufgeschleudert wird und das Lösungsmittel (N-Methylpyrrolidon) in einem Umluftofen bei 80°C entfernt wird. Die so beschichtete Platte wird durch eine Photomaske (21 step Stouffer sensivity guide) mit einer 1000 Watt-UV-Lampe bei Raumtemperatur aus 18 cm Entfernung belichtet. Die so belichtete Platte wird anschliessend mit N-Methylpyrrolidon (NMP) entwickelt, wobei die unbelichteten Anteile des Polymerfilms weggelöst werden. Die Sichtbarmachung des Bildes erfolgt durch Aetzen der so freigelegten Kupferschicht mit $FeCl_3$-Lösung. Bei einer Belichtungszeit von 240 Sekunden wird eine Empfindlichkeit von 6 - 7 erzielt.

**Beispiele 2 - 13**

Analog Beispiel 1 werden Polyamide hergestellt, indem verschiedene Diamine mit stöchiometrischen Mengen Benzophenon-4,4'-dicarbonsäurechlorid in NMP zur Reaktion gebracht werden. In den Beispielen 6, 7, 8, 9, 12 und 13 wird anstelle von Triäthylamin für die Bindung von HCl eine entsprechende Menge Propylenoxyd eingesetzt.

Die physikalischen Daten und die Empfindlichkeit unter den in Beispiel 1 angegebenen Bestrahlungsbedingungen sind in Tabelle 1 zusammengefasst.

**Beispiel 14**

In einer Apparatur wie in Beispiel 1 beschrieben werden 1,99 g 4,4'-Diaminodiphenylmethan in 25 ml NMP gelöst und bei -15°C unter Stickstoff und unter Rühren 3,145 g Benzophenon-3,4,4'-tricarbonsäureanhydridchlorid zugegeben. Nachdem alles in Lösung gegangen ist, wird die Kühlung weggenommen und 1,5 Stunden gerührt. Nach Zugabe von 0,65 g Propylenoxyd wird weitere 3,5 Stunden bei Raumtemperatur gerührt. Dann werden 2,2 g Triäthylamin und 4,6 g Essigsäureanhydrid zugetropft und die Lösung 16 Stunden bei Raumtemperatur gerührt. Die Isolierung des Polyamidimides erfolgt durch Ausfällen mit Wasser wie in Beispiel 1 beschrieben. Die physikalischen Eigenschaften und die Empfindlichkeit unter den in Beispiel 1 angegebenen Bestrahlungsbedingungen sind in Tabelle 1 aufgeführt.

**Beispiele 15 - 18**

Analog Beispiel 14 werden verschiedenen Polyamidimide aus Diaminen und Benzophenon-3,4,4'-tricarbonsäureanhydridchlorid hergestellt und zur photographischen Reliefbilderzeugung benutzt. In den Beispielen 15 und 18 wird Triäthylamin anstelle von Propylenoxyd zur Bindung von HCl eingesetzt. Physikalische Eigenschaften und die Empfindlichkeit unter der in Beispiel 1 angegebenen Bestrahlungsbedingungen sind in Tabelle 1 zusammengefasst.

**Beispiel 19**

In einem zylindrischen Gefäss mit Metallrührer und Destillationsaufsatz werden 4,52 g 2,2-Dimethyl-11-amino-11-isopropylundecanol(1) und 5,625 g Benzophenon-3,4,4'-tricarbonsäure vermischt und unter Durchleiten von Stickstoff auf 190°C aufgeheizt. Im Verlaufe von 2 Stunden wird die Temperatur auf 240°C gesteigert. Nachdem die Temperatur auf 220°C gestellt wird, wird 1 g Aethylenglykol zugesetzt und die Temperatur wieder langsam auf 250°C gesteigert. Nach 3 Stunden werden 600 ppm Tetraisopropyl-o-titanat zugesetzt und noch 2 Stunden - zuerst unter Wasserstrahlvakuum dann unter Hochvakuum ( < I Torr) - bei 250°C weiterkondensiert. Nach Abkühlen auf Raumtemperatur wird das Polyesterimid mit NMP aus dem Gefäss herausgelöst und durch Fällen in Wasser isoliert. Die Eigenschaften und die Empfindlichkeit sind in Tabelle 1 aufgeführt.

**Beispiel 20**

5,12 g 3,3',5,5'-Tetramethyl-4,4'-dihydroxydiphenylmethan werden in einer Mischung von 40 ml 1 N NaOH und 300 ml Wasser gelöst und in einen Haushaltmixer gegeben. Unter starkem Rühren wird eine Lösung von 6,14 g Benzophenon-4,4'-dicarbonsäurechlorid in 20 ml Chlorbenzol hinzugeschüttet und 10 Minuten lang die Mischung weitergerührt. Der ausgefallene Polyester wird abfiltriert, in 500 ml Alkohol 15 Minuten lang gerührt, erneut abfiltriert und im Vakuum bei 80° getrocknet. Physikalische Eigenschaften und Empfindlichkeit sind in Tabelle 1 angegeben.

**Beispiel 21**

5,7 g Butandiol(1,4), 5,18 g Benzophenon-4,4'-dicarbonsäureäthylester und 700 ppm Tetraisopropyl-o-titanat werden in einem zylindrischem Gefäss mit Rührer und Destillationsaufsatz unter Durchleiten von Stickstoff auf 170°C aufgeheizt und 3 Stunden bei dieser Temperatur unter Normaldruck gehalten. Nachdem die Umesterung abgeschlossen ist, wird

langsam Vakuum angelegt. Nachdem ein Druck von < I Torr erreicht ist, wird 2 Stunden lang polykondensiert. Nach Abkühlen auf Raumtemperatur wird der Polyester mechanisch aus dem Polykondensationsgefässs entfernt. Eigenschaften und Empfindlichkeit sind in Tabelle 1 angegeben.

**Beispiel 22**

3,54 g technischer Bisphenol A-bisglycidyläther, 3,14 g Benzophenon-4,4'-dicarbonsäure und 0,037 ml Benzyldimethylamin in 38 ml NMP werden unter Stickstoff 7 Stunden bei 135°C gerührt. Nach dem Erkalten wird die Lösung direkt für die Filmbildung auf der kupferkaschierten Platte verwendet. Daten für die Reliefbilderzeugung siehe Tabelle 1.

**Beispiel 23**

Analog Beispiel 21 werden 3,59 g Benzophenon-4,4'-dicarbonsäureäthylester mit 5,38 g Thiodiäthylenglykol umgeestert und anschliessend im Vakuum polykondensiert. Eigenschaften und Empfindlichkeit siehe Tabelle 1.

**Beispiele 24 - 26**

Analog Beispiel 1 werden verschiedene Diamine mit stöchiometrischen Mengen Benzophenondicarbonsäurechlorid umgesetzt. Anstelle von NMP wird in diesen Fällen eine Mischung von NMP und Methylenchlorid als Lösungsmittel verwendet. Zusammensetzung, Eigenschaften und Empfindlichkeit sind in Tabelle 1 angegeben.

**Beispiele 27 - 29**

Analog Beispiel 1 werden Polyamide hergestellt, indem verschiedene Diamine mit stöchiometrischen Mengen (1,3-Phenylendicarbonyl)-bis-4,4'-benzoylchlorid in NMP zur Reaktion gebracht werden. Die physikalischen Daten und die Empfindlichkeit sind in Tabelle 1 zusammengefasst.

**Beispiel 30**

3,57 g technischer Bisphenol-A-bisglycidyläther, 4,39 g (1,4-Phenylendicarbonyl)-bis-4,4'-benzoesäure und 0,04 ml Benzyldimethylanilin werden in 30 ml NMP 8 Stunden lang auf 130°C erwärmt. Nach dem Erkalten wird die Lösung direkt für die Filmbildung auf einer kupferkaschierten Platte verwendet. Physikalische Daten und die Empfindlichkeit sind in Tabelle 1 angegeben.

**Tabelle 1**

| Beispiel | Zusammenzetsung Komponente 1 | Komponente 2 | η red. (dl/g) | Tg (°C) | Belichtungszeit (Sekunden) | Entwickler | Empfindlichkeit (abgebildete Stufen) |
|---|---|---|---|---|---|---|---|
| 2 | N,N'-Dicyclohexyl-1,6-diaminohexan | BDCC[1)] | 0,51 | 123 | 180 | NMP | 7 - 8 |
| 3 | DDM[2)] | BDCC | 0,87 | 271 | 300 | NMP | 5 |
| 4 | m-Phenylendiamin | BDCC | 0,66 | 275 | 900 | NMP/TCA[3)] | 7 |
| 5 | 3,3'1,5,5'-Tetramethyl-DDM | BDCC | 0,70 | 285 | 120 | NMP | 4 - 5 |
| 6 | 2,4-Diaminotoluol | BDCC | 0,73 | 288 | 900 | NMP/$CHCl_3$ | 4 |
| 7 | 3,3'-Dimethyl-5,5'-diäthyl-DDM | BDCC | 0,85 | 273 | 120 | NMP/$CHCl_3$ | 5 - 6 |
| 8 | 2-Amino-6-methyl-6-(3-äthyl-4-aminophneyl)-heptan | BDCC | 0,31 | 180 | 600 | NMP/$CHCl_3$ | 4 |
| 9 | m-Xylylendiamin | BDCC | 0,33 | 177 | 180 | NMP/$CHCl_3$ | 3 - 4 |
| 10 | Piperazin | BDCC | 0,41 | 256 | 180 | $CHCl_3$ | 4 |
| 11 | 2,5-Dimethylpiperazin | BDCC | 0,48 | 235 | 150 | NMP | 5 |
| 12 | 3,3'-Diisopropyl-DDM | BDCC | 0,64 | 204 | 180 | NMP/$CHCl_3$ | 3 |
| 13 | 1,11-Diamino-1-isopropyl-10,10-dimethyl-undecan | BDCC | 0,40 | 123 | 120 | NMP | 6 |
| 14 | DDM | BTCAC[4)] | 1,20 | 256 | 300 | NMP | 2 - 3 |

| | | | | | | | |
|---|---|---|---|---|---|---|---|
| 15 | 3,3'-Dimethyl-DDM | BTCAC | 0,63 | 239 | 300 | NMP | 2 - 3 |
| 16 | 2,4-Diaminotoluol | BTCAC | 0,81 | 296 | 600 | NMP | 6 - 7 |
| 17 | 3,3',5,5'-Tetramethyl-DDM | BTCAC | 1,13 | 300 | 180 | NMP | 8 - 9 |
| 18 | 1,10-Diamino-1,10-di-n-hexldecan | BTCAC | 0,20 | 57 | 30 | NMP | 6 - 7 |
| 19 | 2,2-Dimethyl-11-amino-11-isopropylundecanol (1) | BTC[5)] | 0,59 | 84 | 15 | NMP/$CHCl_3$ | 6 - 7 |
| 20 | 3,3'5,5'-Tetramethyl-4,4'-dihydroxydiphenyl-methan | BDCC | 0,30 | 172 | 300 | $CHCl_3$ | 3 |
| 21 | Butandiol (1,4) | BDCE[6)] | 0,43 | 67 | 20 | $CHCl_3$ | 7 - 8 |
| 22 | Bisphenol-A-bisglycidyl-äther | BDC[7)] | n.b.[8)] | n.b.[8)] | 300 | NMP | 6 |
| 23 | Thiodiäthylenglykol | BDCE | 0,14 | n.b. | 180 | $CHCl_3$ | 5 |
| 24 | N,N'-Diisopropyl-hexa-methylendiamin | BDCC | 0,40 | 100 | 150 | $CHCl_3$ | 4 |
| 25 | 1,10-Diamino-1,10-di-methyldecan | BDCC | 0,65 | 133 | 120 | NMP | 6 - 7 |
| 26 | 1,10-Diamino-1,1,10,10- | BDCC | 0,40 | 113 | 120 | NMP | 5 - 6 |
| 27 | 4,4'-Diaminodiphenyl-methan | 9) | 0,52 | 224 | 360 | NMP | 3 |
| 28 | 1,11-Diamino-1-dimethylun-pyl-10,10-dimethylun-decan | 9) | 0,49 | 117 | 500 | NMP | 4 |
| 29 | 3,3',5,5'-Tetramethyl-4,4'-diaminodiphenyl-methan | 9) | 0,50 | 229 | 500 | NMP | 6 - 7 |
| 30 | Bisphenol-A-bisglyci-dyläther | 10) | 0,15 | 95 | 120 | NMP | 2 |

1)BDCC = Benzophenon-4,4'-dicarbonsäuredichlorid
2)DDM = 4,4'-Diaminodiphenylmethan
3)TCA = 1,1,1-Trichloräthan
4)BTAC = Benzophenon-3,4,4'-tricarbonsäureanhydridchlorid
5)BTC = Benzophenon-3,4,4'-tricarbonsäure
6)BDCE = Benzophenon-4,4'-dicarbonsäurerediäthylester
7)BDC = Benzophenon-4,4'-dicarbosäure
8)n.b. = nicht bestimmt
9) (1,3-Phenylendicarbonyl)-bis-4,4'-benzoylchlorid
10) (1,4-Phenylendicarbonyl)-bis-4,4'-benzoesäure

## Patentansprüche

1. Strahlungsempfindliche lineare gesättigte Homo- und Copolykondensate aus der Gruppe der Polyester, Polyesteramide, Polyamide, Polyesterimide und Polyamidimide mit Benzophenondi-oder-tricarbonsäureresten mit mindestens einem wiederkehrenden Strukturelement der Formeln (I) und/oder (II),

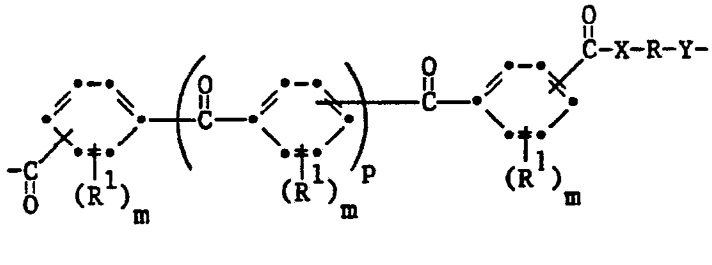

(I)

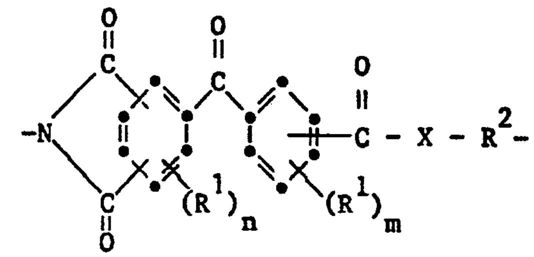

(II)

und im Fall von Copolykondensaten zusätzlich wiederkehrenden Strukturelementen der Formeln (III) und/oder (IV)

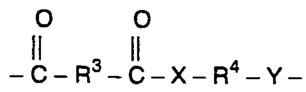

(III)

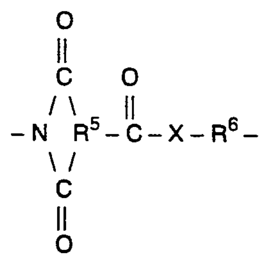

(IV),

worin die Imidgruppe im Strukturelement (II) an zwei benachbarte C-Atome gebunden ist, m für O oder eine Zahl von 1 bis 4 steht, p für O oder eine Zahl von 1 bis 5 steht und n für O oder eine Zahl von 1 bis 3 steht, X für -S-, -O- oder $-NR^7-$ steht und Y unabhängig die gleiche Bedeutung wie X hat,

$R^1$ Alkyl oder Alkoxy mit weniger als 6 C-Atomen, Aryl mit 6 bis 10 C-Atomen, Aralkyl mit 7 bis 10 C-Atomen oder Halogen bedeutet,
R einen unsubstituierten oder substituierten zweiwertigen aliphatischen, cycloaliphatischen, arylphatischen oder aromatischen Rest bedeutet, und falls X und Y die Gruppe $-NR^7-$ sind, R und eines der $R^7$ zusammen Alkylen mit 5 bis 7 C-Atomen, an das die zweite $-NR^7$-Gruppe gebunden ist, oder R Methylen, Aethylen oder Propylen und die beiden $R^7$ der $NR^7$-Gruppen zusammen Aethylen oder Propylen oder falls X oder Y -S- oder -O- und das andere $-NR^7-$ sind, R und $R^7$ zusammen Alkylen mit 5 - 7 C-Atomen bedeuten,
$R^2$ einen unsubstituierten oder substituierten zweiwertigen aliphatischen oder aromatischen Kohlenwasserstoffrest bedeutet und falls X die $-NR^7$-Gruppe ist, $R^2$ und $R^7$ zusammen Alkylen mit 5 bis 7 C-Atomen bedeuten,
$r^4$ unabhängig die gleiche Bedeutung wie R und $R^6$ unabhängig die gleiche Bedeutung wie $R^2$ hat,
$R^3$ ein zweitwertiger gesättigter aliphatischer oder aromatischer Rest ist,
$R^5$ für einen dreiwertigen gesättigten aliphatischen oder aromatischen Rest steht, in dem die Imidgruppe an zwei benachbarte C-Atome gebunden ist, und
$R^7$ ein Wasserstoffatom, Alkyl, Cycloalkyl, Aryl, Aralkyl oder Alkaralkyl bedeutet,

wobei die Copolykondensate die Strukturelemente der Formeln (I) und/oder (II) zu mindestens 10 Mol.-% enthalten, bezogen auf das Copolykondensat.

2. Polykondensate gemäss Anspruch 1, dadurch gekennzeichnet, dass die Strukturelemente der Formel (I) und/oder (II) zu mindestens 50 Mol.-% bevorzugt zu mindestens 70 Mol.-% und insbesondere zu mindestens 90 Mol.-% im Copolykondensat enthalten sind.

3. Polykondensate gemäss Anspruch 1, dadurch gekennzeichnet, dass p, m und n in den Strukturelementen der Formeln (I) und (II) für 1 und besonders für O stehen.

4. Polykondensate gemäss Anspruch 1, dadurch gekennzeichnet, dass $R^1$ Methyl, Aethyl, Methoxy, Br oder Cl bedeutet.

5. Polykondensate gemäss Anspruch 1, dadurch gekennzeichnet, dass $R^7$ Alkyl mit 1 bis 6 C-Atomen, Cycloalkyl mit 5 oder 6 Ringkohlenstoffatomen, Phenyl oder Benzyl und besonders ein Wasserstoffatom ist.

6. Polykondensate gemäss Anspruch 1, dadurch gekennzeichnet, dass die Carbonylgruppen in den Strukturelementen der Formeln (I) und (II) in Metastellung und besonders in Parastellung zur Carbonylbrückengruppe und die Imidgruppe im Strukturelement der Formel (II) in Ortho-/Metastellung und besonders in Meta-/Parastellung zur Carbonylbrückengruppe gebunden ist.

7. Polykondensate gemäss Anspruch 1, dadurch gekennzeichnet, dass R, $R^2$, $R^4$ und $R^6$ als aliphatischer Rest 2 bis 30 C-Atome, als cycloaliphatischer Rest 5 bis 8 Ring-C-Atome, als araliphatischer Rest 7 bis 30 C-Atome und als aromatischer Rest 6 bis 30 C-Atome enthalten.

8. Polykondensate gemäss Anspruch 1, dadurch gekennzeichnet, dass X und Y in den Formeln (I) bis (IV) für die Gruppe $-NR^7$ - stehen und der aliphatische oder araliphatische Rest 6 bis 22 C-Atome enthält oder X und Y in den Formeln (I) bis (IV) für -O- stehen und der aliphatische Rest 2 bis 12 C-Atome enthält.

9. Polykondensate gemäss Anspruch 1, dadurch gekennzeichnet, dass R, $R^2$, $R^4$ und $R^6$ unabhängig voneinander als aliphatischer Rest lineares oder verzweigtes Alkylen sind, das durch Sauerstoffatome, NH, $NR^a$ oder $^{\oplus}NR^a_2G^{\ominus}$, worin $R^a$ Alkyl mit 1 bis 12 C-Atomen oder Cycloalkyl mit 5 oder 6 Ring-C-Atomen, Phenyl oder Benzyl ist und $G^{\ominus}$ das Anion einer Protonensäure ist, Cyclohexylen, Naphthylen, Phenylen oder Hydantoine unterbrochen sein kann; als cycloaliphatischer Rest unsubstituiertes oder durch Alkyl substituiertes Mono- oder bicyclisches Cycloalkylen mit 5 bis 7 Ring-C-Atomen; als araliphatischer Rest unsubstituiertes oder am Aryl durch Alkyl substituiertes Aralkylen ist, wobei der Alkylenrest linear oder verzweigt sein kann; und als aromatischer Rest ein unsubstituierter oder durch Alkyl, Alkoxy, Alkoxyalkyl, Trimethylen oder Tetramethylen substituierter Kohlenwasserstoffrest oder Pyridinrest sind.

10. Polykondensate gemäss Anspruch 9, dadurch gekennzeichnet, dass R, $R^2$, $R^4$ und $R^6$ als aliphatischer Rest lineares oder verzweigtes Alkylen mit 2 bis 30 C-Atomen, $-(CH_2)_x-R^8-(CH_2)_y-$, worin $R^8$ Phenylen, Naphthylen, Cyclopentylen oder Cyclohexylen und x und y unabhängig voneinander eine Zahl von 1, 2 oder 3 sind, $-R^9-(-OR^{10}-)_p-O-R^9-$, worin $R^9$ Aethylen, 1,2-Propylen, 1,3-propylen oder 2-Methyl-1,3-propylen und $R^{10}$ Aethylen, 1,2-Propylen, 1,2-Butylen, 1,3-Propylen oder 1,4-Butylen und p eine Zahl von 1 bis 100 sind, oder

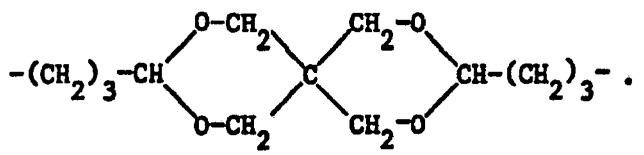

ist.

11. Polykondensate gemäss Anspruch 9, dadurch gekennzeichnet, dass R, $R^2$, $R^4$ und $R^6$ als cycloaliphatischer Rest solche der Formeln

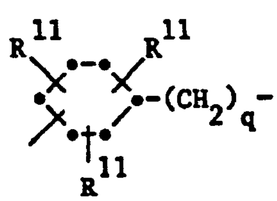

oder

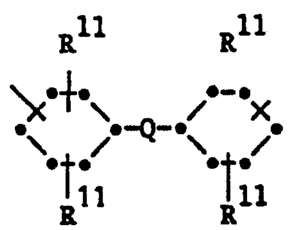

sind, worin q = O oder 1 ist, $R^{11}$ unabhängig Wasserstoff oder Alkyl mit 1 bis 6 C-Atomen bedeutet, und Q für eine direkte Bindung, O, S, $SO_2$, Alkylen mit 1 bis 3 C-Atomen oder Alkyliden mit 2 bis 6 C-Atomen steht.

12. Polykondensate gemäss Anspruch 9, dadurch gekennzeichnet, dass R, $R^2$, $R^4$ und $R^6$ als aromatischer Rest durch Alkyl, Alkoxy oder Alkoxyalkyl mit 1 bis 6 C-Atomen oder zwei benachbarte C-Atome des aromatischen Restes durch Trimethylen oder Tetramethylen substituiert sind.

13. Polykondensate gemäss Anspruch 12, dadurch gekennzeichnet, dass X und Y in den Formeln I bis IV die Gruppe $-NR^7-$ bedeuten und ein oder zwei Substituenten in Orthostellung zur $-NR^7$-Gruppe gebunden sind.

14. Polykondensate gemäss Anspruch 9, dadurch gekennzeichnet, dass der araliphatische Rest der Formel

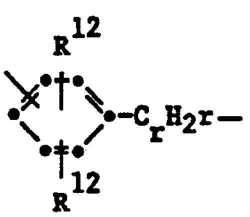

entspricht, worin die $R^{12}$ unabhängig ein Wasserstoffatom oder Alkyl mit 1 bis 6 C-Atomen und r ganze Zahlen von 1 bis 16 bedeuten.

15. Polykondensate gemäss Anspruch 14, dadurch gekennzeichnet, dass die freie Bindung in p-Stellung zur $C_rH_{2r}$-Gruppe steht und ein oder beide $R^{12}$ als Alkyl in o-Stellung zur freien Bindung gebunden sind.

16. Polykondensate gemäss Anspruch 9, dadurch gekennzeichnet, dass der aromatische Rest den Formeln

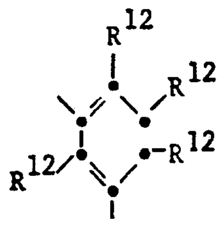 , 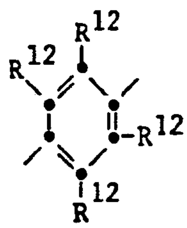 , 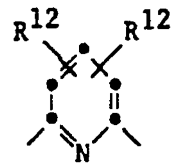 ,

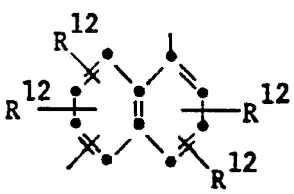 , 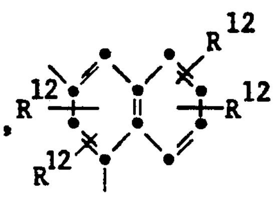 , 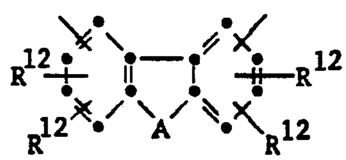

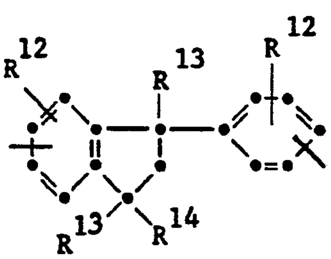 oder

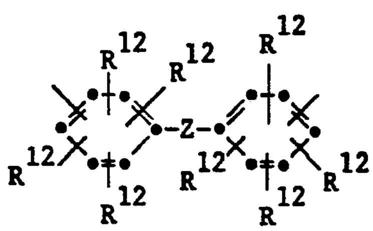 ,

entspricht, worin $R^{12}$ ein Wasserstoffatom oder $R^{12}$ im Falle der Monosubstitution Alkyl mit 1 bis 6 C-Atomen und die anderen $R^{12}$ Wasserstoff sind, und im Falle der Di-, Tri- oder Tetrasubstitution zwei $R^{12}$ Alkyl mit 1 bis 6 C-Atomen und die anderen $R^{12}$ ein Wasserstoffatom oder Alkyl mit 1 bis 6 C-Atomen sind oder im Falle der Di-, Tri- oder Tetrasubstitution zwei vicinale $R^{12}$ im Phenylring für Trimethylen oder Tetramethylen und die anderen $r^{12}$ für ein Wasserstoffatom oder Alkyl mit 1 bis 6 C-Atomen stehen, A für O, S, NH, CO oder $CH_2$ steht, $R^{13}$ ein Wasserstoffatom oder Alkyl mit 1 bis 5 C-Atomen und $R^{14}$ Alkyl mit 1 bis 5 C-Atomen darstellt, und Z eine direkte Bindung, O, S, SO, $SO_2$, CO, $\overset{O}{\overset{\|}{C}}O$, $\overset{O}{\overset{\|}{C}}NR^{15}$, $NR^{15}$, CONH, NH, $R^{15}SiR^{16}$, $R^{15}OSiOR^{16}$, Alkylen mit 1 bis 6 C-Atomen, Alkenylen oder Alkyliden mit 2 bis 6 C-Atomen, Phenylen oder Phenyldioxyl bedeutet, worin $R^{15}$ und $R^{16}$ unabhängig voneinander Alkyl mit 1 bis 6 C-Atomen oder Phenyl bedeuten.

17. Polykondensate gemäss Anspruch 16, dadurch gekennzeichnet, dass der aromatische Rest

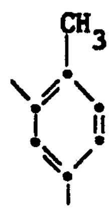 , 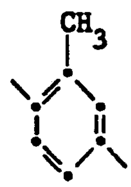 , 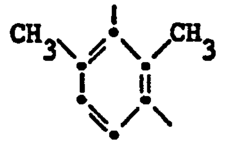 , 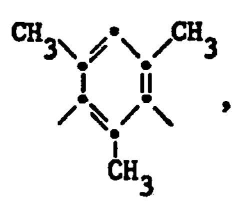 , 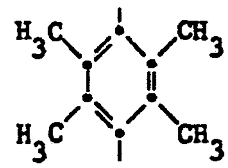 ,

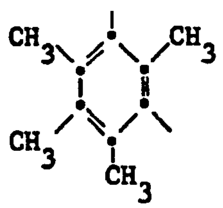 oder 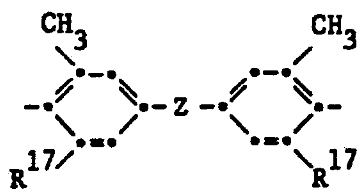

ist,worin Z eine direkte Bindung, O und besonders $CH_2$ bedeutet und $R^{17}$ ein Wasserstoffatom, Methyl oder Aethyl darstellt.

18. Polykondensate gemäss Anspruch 1, dadurch gekennzeichnet, dass X und Y in den Formeln (I) bis (IV) für die $-NR^7$-Gruppe stehen und R, $R^2$, $R^4$ und $R^6$ einem Rest gemäss Anspruch 17 bedeuten, worin $R^{17}$ Methyl oder Aethyl ist, oder verzweigtes Alkylen mit 6 bis 20 C-Atomen bedeuten, das bevorzugt in α-Stellung zur $-NR^7$-Gruppe verzweigt ist.

19. Polykondensate gemäss Anspruch 8, dadurch gekennzeichnet, dass X und Y in den Formeln (I) bis (IV) für -O- stehen und R, $R^2$, $R^4$ und $R^6$ verzweigtes und besonders lineares Alkylen mit 2 bis 12 C-Atomen bedeuten.

20. Polykondensate gemäss Anspruch 1, dadurch gekennzeichnet, dass $R^3$ in Formel (III) lineares oder verzweigtes Alkylen mit 2 bis 12 C-Atomen, Cycloalkylen mit 5 bis 7 Ringkohlenstoffatomen oder ein aromatischer Kohlenwasserstoffrest mit 6 bis 18 C-Atomen ist.

21. Polykondensate gemäss Anspruch 1, dadurch gekennzeichnet, dass $R^5$ in Formel (IV) 1,2,4-Phentriyl bedeutet.

22. Polykondensate gemäss Anspruch 1, dadurch gekennzeichnet, dass sie die Strukturelemente

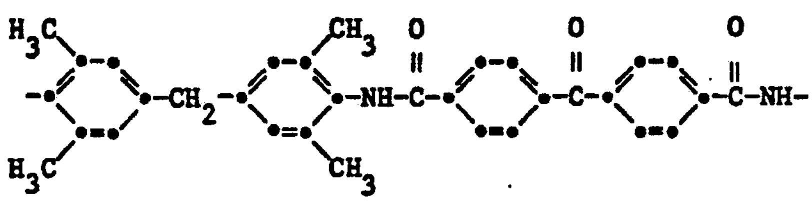 oder

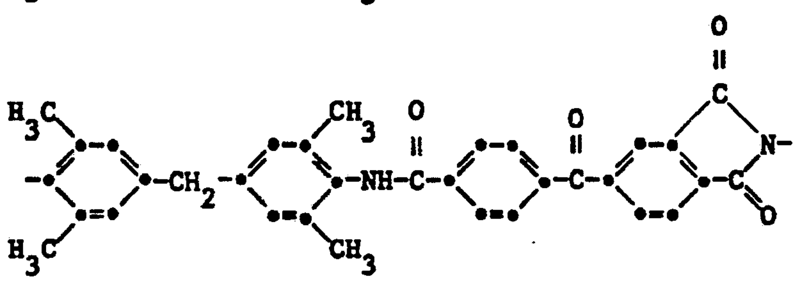 oder

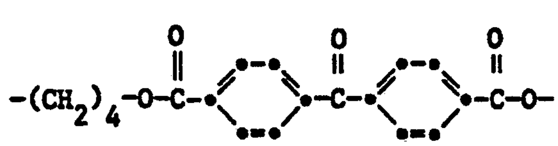

enthalten.

23. Verfahren zur Herstellung von Polykondensaten gemäss Anspruch 1, dadurch gekennzeichnet, dass man Benzophenondicarbonsäure der Formel (V)

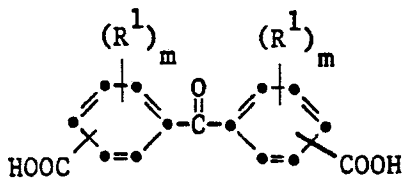

(V)

oder eine Benzophenontricarbonsäure der Formel (VI)

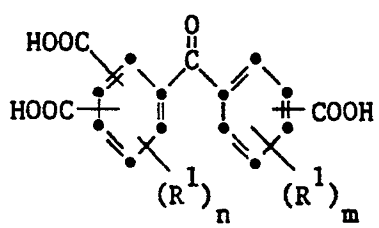

(VI)

oder Gemische dieser Säuren in einer Menge von mindestens 10 Mol.-%, bezogen auf das Polykondensat, gegebenenfalls zusammen mit einer Dicarbonsäure der Formel (VII) und/oder einer Tricarbonsäure der Formel (VIII)

$HOOC-R^3-COOH$ (VII)

HOOC
\
$R^5$-COOH (VIII)
/
HOOC

oder deren Polyester- oder Polyamid bildenden Derivate mit einem Diol, Dimercaptan, einem Diamin, einem Aminoalkohol, einem Aminomerkaptan, einem Hydroxymerkaptan der Formel (IX) oder mit Gemischen dieser Monomeren

HX - R - YH (IX),

worin m, n, $R^1$, $R^3$, $R^5$ und $R^7$ die angegebenen Bedeutung haben und X und Y entweder für -O-, -S- oder für $-NHR^7$- oder X für -O- oder -S- und Y für $-NHR^7$ stehen, polykondensiert.

24. Beschichtetes Material, enthaltend auf einem Träger eine Schicht eines Polykondensates gemäss Anspruch 1.

25. Verwendung des Materials gemäss Anspruch 24 zur Herstellung von Schutzschichten oder photographischen Abbildungen durch Bestrahlen, gegebenenfalls durch eine Photomaske und anschliessendes Entfernen der nicht bestrahlten Anteile des Polykondensates.

## Claims

1. A radiation-sensitive linear saturated homopolycondensate or copolycondensate of the group comprising polyesters, polyester-amides, polyamides, polyester-imides and polyamide-imides with benzophenone-dior -tri-carboxylic acid radicals, with at least one of the recurring structural elements of the formula (I) and/or (II)

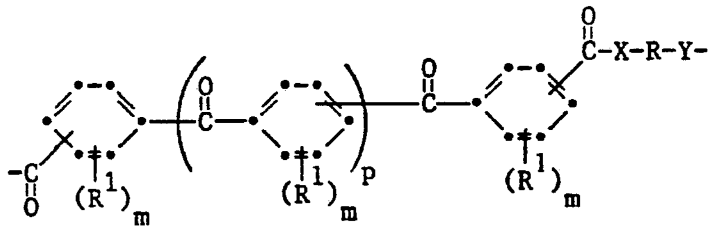

(I)

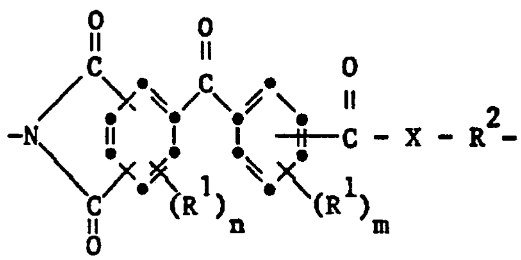

(II)

and, in the case of a copolycondensate, also recurring structural elements of the formula (III) and/or (IV)

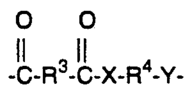

(III)

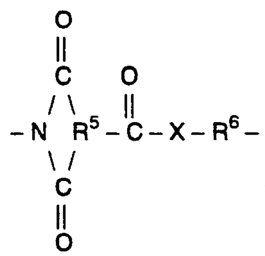

(IV)

in which the imide group in structural element (II) is bonded to two adjacent C atoms, m is O or a number from 1 to 4, p is O or a number from 1 to 5 and n is O or a number from 1 to 3, X is -S-, -O- or $-NR^7-$ and Y independently has the same meaning as X, $R^1$ is alkyl or alkoxy having less than 6 C atoms, aryl having 6 to 10 C atoms, aralkyl having 7 to 10 C atoms or halogen, R is an unsubstituted or substituted divalent aliphatic, cycloaliphatic, araliphatic or aromatic radical and, if X and Y are the group $-NR^7-$, R and one of the radicals $R^7$ together are alkylene having 5 to 7 C atoms, to which the second $-NR^7-$ group is bonded, or R is methylene, ethylene or propylene and the two radicals $R^7$ of the $NR^7$ groups together are ethylene or propylene, or, if X or Y is -O- or -S- and the other is $-NR^7-$, R and $R^7$ together are alkylene having 5 - 7 C atoms, $R^2$ is an unsubstituted or substituted divalent aliphatic or aromatic hydrocarbon radical or, if X is the $-NR^7-$ group, $R^2$ and $R^7$ together are alkylene having 5 to 7 C atoms, $R^4$ independently has the same meaning as R, and $R^6$ independently has the same meaning as $R^2$, $R^3$ is a divalent saturated aliphatic or aromatic radical, $R^5$ is a trivalent saturated aliphatic or aromatic radical in which the imide group is bonded to two adjacent C atoms and $R^7$ is a hydrogen atom, alkyl, cycloalkyl, aryl, aralkyl or alkaralkyl, the copolycondensates containing at least 10 mol-%, based on the copolycondensate, of structural elements of the formula (I) and/or (II).

2. A polycondensate according to claim 1, which contains at least 50 mol-%, preferably at least 70 mol-% and in particular at least 90 mol-%, of structural elements of the formula (I) and/or (II).

3. A polycondensate according to claim 1, in which p, m and n in the structural elements of the formulae (I) and (II) are 1 or, in particular, 0.

4. A polycondensate according to claim 1, in which $R^1$ is methyl, ethyl, methoxy, Br or Cl.

5. A polycondensate according to claim 1, in which $R^7$ is alkyl having 1 to 6 C atoms, cycloalkyl having 5 or 6 ring carbon atoms, phenyl, benzyl or, in particular, a hydrogen atom.

6. A polycondensate according to claim 1, in which the carbonyl groups in the structural elements of the formulae (I) and (II) are bonded in the meta-position or, in particular, in the para-position relative to the carbonyl bridge group and the imide group in the structural element of the formula (II) is bonded in the ortho-/meta-position, in particular in the

meta-/para-position, relative to the carbonyl bridge group.

7. A polycondensate according to claim 1, in which R, $R^2$, $R^4$ and $R^6$ contain 2 to 30 C atoms as an aliphatic radical, 5 to 8 ring C atoms as a cycloaliphatic radical, 7 to 3O C atoms as an araliphatic radical and 6 to 30 C atoms as an aromatic radical.

8. A polycondensate according to claim 1, in which X and Y in formulae (I) to (IV) are the group $-NR^7-$ and the aliphatic or araliphatic radical contains 6 to 22 C atoms, or X and Y in formulae (I) to (IV) are -O- and the aliphatic radical contains 2 to 12 C atoms.

9. A polycondensate according to claim 1, in which R, $R^2$, $R^4$ and $R^6$ independently of one another are, as an aliphatic radical, linear or branched alkylene which can be interrupted by oxygen atoms, NH, $NR^a$ or $^+NR^a{}_2G^-$, in which $R^a$ is alkyl having 1 to 12 C atoms or cycloalkyl having 5 or 6 ring C atoms, phenyl or benzyl and $G^-$ is the anion of a proton acid, or cyclohexylene, naphthylene, phenylene or a hydantoin; or, as a cycloaliphatic radical, monocyclic or bicyclic cycloalkylene which has 5 to 7 ring C atoms and is unsubstituted or substituted by alkyl; or, as an araliphatic radical, aralkylene which is unsubstituted or substituted on the aryl by alkyl, it being possible for the alkylene radical to be linear or branched; or, as an aromatic radical, are a hydrocarbon radical or pyridine radical which is unsubstituted or substituted by alkyl, alkoxy, alkoxyalkyl, trimethylene or tetramethylene.

10. A polycondensate according to claim 9, in which R, $R^2$, $R^4$ and $R^6$, as an aliphatic radical, are linear or branched alkylene having 2 to 30 C atoms, $-(CH_2)_x-R^8-(CH_2)_y-$, in which $R^8$ is phenylene, naphthylene, cyclopentylene or cyclohexylene and x and y independently of one another are the number 1, 2 or 3, $-R^9-(-OR^{10}-)_p-O-R^9-$, in which $R^9$ is ethylene, 1, 2-propylene, 1,3-propylene or 2-methyl-1,3-propylene and $R^{10}$ is ethylene, 1,2-propylene, 1,2-butylene, 1,3-propylene or 1,4-butylene and p is a number from 1 to 100, or

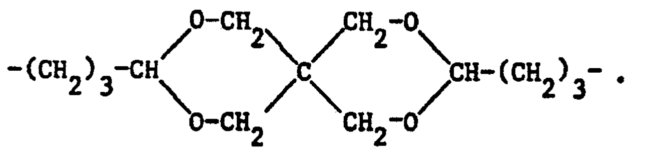

11. A polycondensate according to claim 9, in which R, $R^2$, $R^4$ and $R^6$, as a cycloaliphatic radical, are one of the formulae

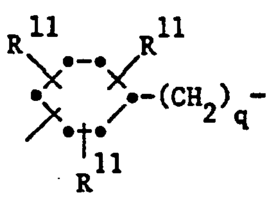

or

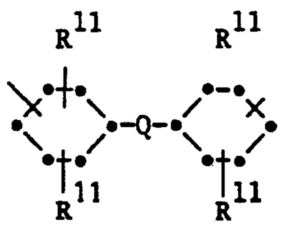

in which q is 0 or 1, the radicals $R^{11}$ independently are hydrogen or alkyl having 1 to 6 C atoms and Q is a direct bond, O, S, $SO_2$, alkylene having 1 to 3 C atoms or alkylidene having 2 to 6 C atoms.

12. A polycondensate according to claim 9, in which R, $R^2$, $R^4$ and $R^6$, as an aromatic radical, are substituted by alkyl, alkoxy or alkoxyalkyl having 1 to 6 C atoms, or two adjacent C atoms of the aromatic radical are substituted by trimethylene or tetramethylene.

13. A polycondensate according to claim 12, in which X and Y in the formulae I to IV are the group $-NR^7-$ and one or two substituents are bonded in the ortho-position relative to the $-NR^7-$ group.

14. A polycondensate according to claim 9, in which the araliphatic radical has the formula

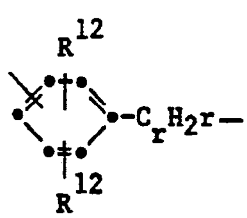

in which the radicals $R^{12}$ independently of one another are hydrogen atoms or alkyl having 1 to 6 C atoms and r is an integer from 1 to 16.

15. A polycondensate according to claim 14, in which the free bond is in the p-position relative to the $C_rH_{2r}$ group and one or both of the radicals $R^{12}$, as alkyl, are bonded in the o-position relative to the free bond.

16. A polycondensate according to claim 9, in which the aromatic radical has the formula

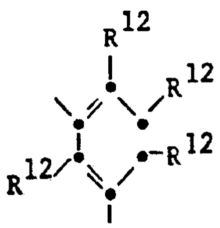 ,

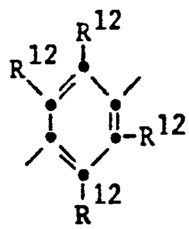 ,

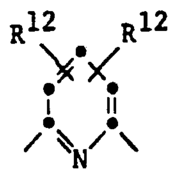 ,

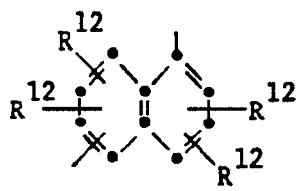 ,

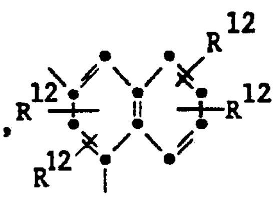 ,

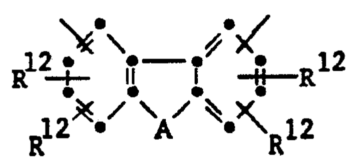

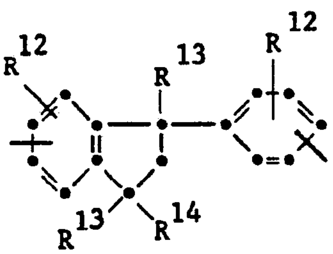

or

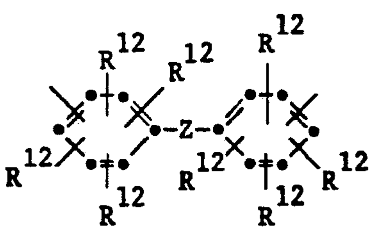 ,

in which the radicals $R^{12}$ are hydrogen atoms or, in the case of monosubstitution, one radical $R^{12}$ is alkyl having 1 to 6 C atoms and the other radicals $R^{12}$ are hydrogen atoms, or, in the case of di-, tri- or tetra-substitution, two of the radicals $R^{12}$ are alkyl having 1 to 6 C atoms and the other radicals $R^{12}$ are hydrogen atoms or alkyl having 1 to 6 C atoms, or, in the case of di-, tri- or tetra-substitution, two vicinal radicals $R^{12}$ in the phenyl ring are trimethylene or tetramethylene and the other radicals $R^{12}$ are hydrogen atoms or alkyl having 1 to 6 C atoms, A is O, S, NH, CO or $CH_2$, $R^{13}$ is a hydrogen atom or alkyl having 1 to 5 C atoms and $R^{14}$ is alkyl having in each case 1 to 5 C atoms, and Z is a direct bond, O, S, SO, $SO_2$, CO,
O O
|| ||
CO, $CNR^{15}$, $NR^{15}$, CONH, NH, $R^{15}SiR^{16}$, $R^{15}OSiOR^{16}$, alkylene having 1 to 6 C atoms, alkenylene or alkylidene having 2 to 6 C atoms, phenylene or phenyldioxyl, in which $R^{15}$ and $R^{16}$ independently of one another are alkyl having 1 to 6 C atoms or phenyl.

17. A polycondensate according to claim 16, in which the aromatic radical is

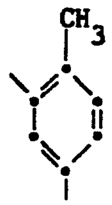, 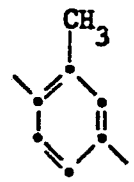, 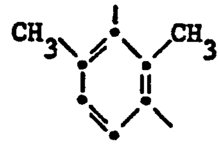, 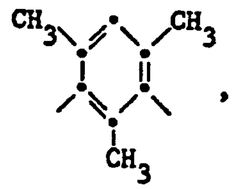, 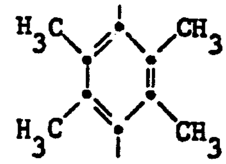,

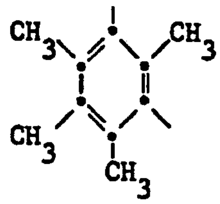 oder 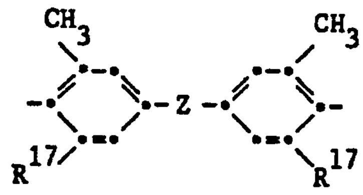

in which Z is a direct bond, O or, in particular, $CH_2$ and $R^{17}$ is a hydrogen atom, methyl or ethyl.

18. A polycondensate according to claim 1, in which X and Y in the formulae (I) to (IV) are the $-NR^7-$ group and R, $R^2$, $R^4$ and $R^6$ are a radical according to claim 17, in which $R^{17}$ is methyl or ethyl, or branched alkylene having 6 to 20 C atoms, which is preferably branched in the -position relative to the $-NR^7-$ group.

19. A polycondensate according to claim 8, in which X and Y in the formulae (I) to (IV) are -O- and R, $R^2$, $R^4$ and $R^6$ are branched or, in particular, linear alkylene having 2 to 12 C atoms.

20. A polycondensate according to claim 1, in which $R^3$ in formula (III) is linear or branched alkylene having 2 to 12 C atoms, cycloalkylene with 5 to 7 ring carbon atoms or an aromatic hydrocarbon radical having 6 to 18 C atoms.

21. A polycondensate according to claim 1, in which $R^5$ in formula (IV) is phen-1,2,4-triyl.

22. A polycondensate according to claim 1, which contains the structural elements

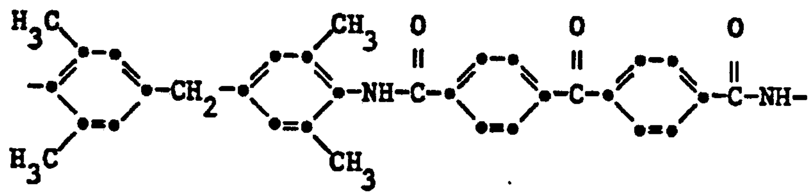

or

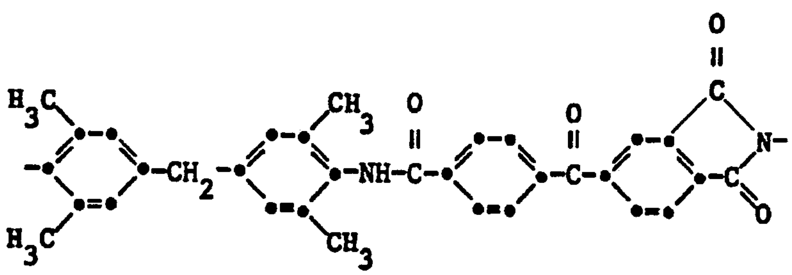

or

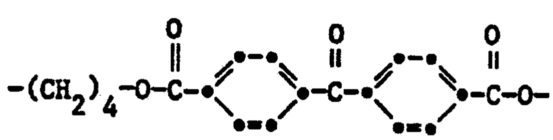

23. A process for the preparation of a polycondensate according to claim 1, which comprises polycondensing a benzophenonedicarboxylic acid of the formula (V)

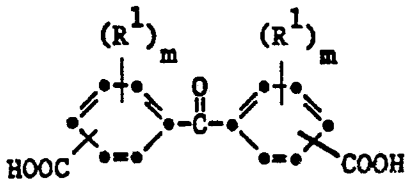

(V)

or a benzophenotricarboxylic acid of the formula (VI)

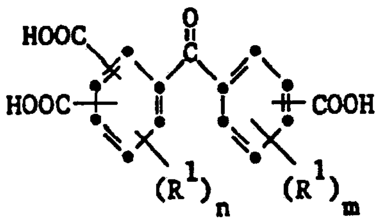

(VI)

or a mixture of these acids in an amount of at least 10 mol-%, based on the polycondensate, if appropriate together with a dicarboxylic acid of the formula (VII) and/or a tricarboxylic acid of the formula (VIII)

$HOOC-R^3-COOH$ (VII)

HOOC
\
$R^5$-COOH (VIII)
/
HOOC

or their polyester- or polyamide-forming derivatives with a diol, dimercaptan, diamine, amino-alcohol, aminomercaptan or hydroxymercaptan of the formula (IX) or a mixture of these monomers

HX - R - YH (IX)

in which m, n, $R^1$, $R^3$, $R^5$ and $R^7$ are as defined and X and Y either are -O-, -S- or $-NR^7-$, or X is -O- or -S- and Y is $-NR^7-$.

24. A coated material containing a layer of a polycondensate according to claim 1 on a carrier.

25. The use of the material according to claim 24 for producing protective layers or photographic images by irradiation, if appropriate through a photomask, and subsequent removal of the non-irradiated portions of the polycondensate.

**Revendications**

1. Homopolycondensats et copolycondensats linéaires saturés, sensibles à un rayonnement, choisis dans l'ensemble constitué par des polyesters, des polyesteramides, des polyamides, des polyesterimides et des polyamidimides comportant des restes acides benzophénone di- ou tri-carboxyliques, et comportant au moins un élément structurel récurrent répondant aux formules (I) et/ou (II) :

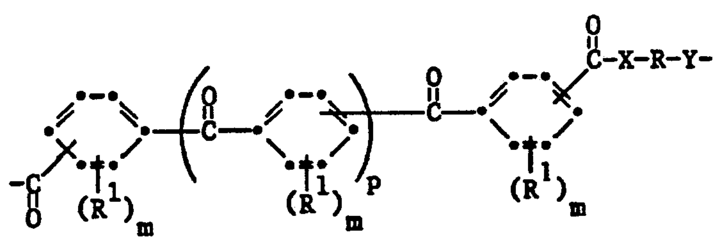

(I)

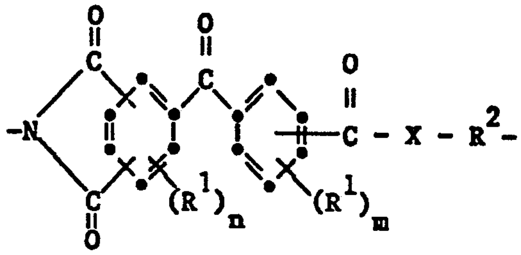 (II)

et, dans le cas de copolycondensats, contenant en outre des éléments structurels récurrents répondant aux formules (III) et/ou (IV) :

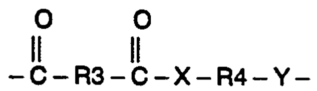 (III)

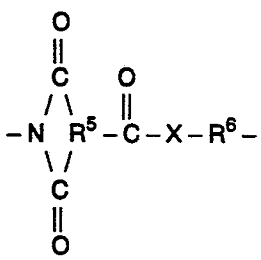 (IV)

dans lesquelles les groupes imides de l'élément structurel (II) sont fixés sur deux atomes de C voisins, m est nul ou représente un nombre valant 1 à 4, p est nul ou représente un nombre valant 1 à 5, et n est nul ou représente un nombre valant 1 à 3, X représente -S-, -O- ou $-NR^7-$, et Y a, indépendamment, le même sens que X, $R^1$ représente un groupe alkyle ou alcoxy ayant moins de 6 atomes de carbone, un groupe aryle ayant 6 à 10 atomes de carbone, aralkyle ayant 7 à 10 atomes de carbone ou un atome d'halogène, R représente un reste divalent aliphatique, cycloaliphatique, araliphatique ou aromatique, substitué ou non substitué et, si X et Y représente le groupe $-NR^7-$, R et l'un des $R^7$ forment ensemble un groupe alkylène ayant 5 à 7 atomes de carbone, sur lequel est fixé le second groupe $-NR^7-$, ou bien R représente un groupe méthylène, éthylène ou propylène et les deux $R^7$ des groupes $NR^7$ forment ensemble un groupe éthylène ou propylène ou bien, si X ou Y représente -S- ou -O- et l'autre représente $-NR^7-$, R et $R^7$ forment ensemble un groupe alkylène ayant 5 à 7 atomes de carbone, $R^2$ représente un reste divalent d'un hydrocarbure aliphatique ou aromatique, substitué ou non substitué, et si X représente le groupe $-NR^7-$, $R^2$ et $R^7$ forment ensemble un groupe alkylène ayant 5 à 7 atomes de carbone, $R^4$ a, indépendamment, le même sens que R et le symbole $R^6$ a, indépendamment, le même sens que $R^2$, $R^3$ représente un reste divalent aliphatique saturé ou aromatique, $R^5$ représente un reste trivalent aliphatique saturé ou aromatique, dans lequel le groupe imide est fixé sur deux atomes de C voisins, et $R^7$ représente un atome d'hydrogène, un groupe alkyle, cycloalkyle, aryle, aralkyle ou alcaralkyle, les copolycondensats comportant, à raison d'au moins 10 moles %, les éléments structurels répondant aux formules (I) et/ou (II), sur la base du copolycondensat.

2. Polycondensats selon la revendication 1, caractérisés en ce que les éléments structurels répondant aux formules (I) et/ou (II) sont contenus à raison d'au moins 50 moles-%, de préférence au moins 70 moles-% et en particulier au moins 90 moles-% dans le copolycondensat.

3. Polycondensats selon la revendication 1, caractérisésen ce que, dans les éléments structurels répondant aux formules (I) et (II), les nombres p, m et n valent 1 et en particulier O.

4. Polycondensats selon la revendication 1, caractérisés en ce que $R^1$ représente un groupe décyle, éthyle, méthoxy, Br ou Cl.

5. Polycondensats selon la revendication 1, caractérisés en ce que $R^7$ représente un groupe alkyle ayant 1 à 6 atomes de carbone, cycloalkyle ayant 5 ou 6 atomes de carbone et cycliques, un groupe phényle ou benzyle et, en particulier, un atome d'hydrogène.

6. Polycondensats selon la revendication 1, caractérisés en ce que, dans les éléments structurels de formule (I) et (II), les groupes carbonyles sont fixés en position méta, et en particulier en position para par rapport au groupe carbonyle de pontage, et le groupe imide est fixé, dans l'élément structurel de formule (II) en position ortho/méta et en particulier en position méta/para par rapport au groupe carbonyle de pontage.

7. Polycondensats selon la revendication 1, caractérisés en ce que les groupes R, $R^2$, $R^4$ et $R^6$ contiennent, à titre de restes aliphatiques, 2 à 30 atomes de carbone, à titre de restes cycloaliphatiques 5 à 8 atomes de carbone et cycliques, à titre de restes araliphatiques 7 à 30 atomes de carbone et à titre de restes aromatiques 6 à 30 atomes de carbone.

8. Polycondensats selon la revendication 1, caractérisés en ce que X et Y représentent, dans les formules (I) à (IV), le groupe $-NR^7-$, et le reste aliphatique ou araliphatique contient 6 à 22 atomes de carbone ou bien X et Y représentent dans les formules (I) à (IV) -O- et le reste aliphatique contient 2 à 10 atomes de carbone.

9. Polycondensats selon la revendication 1, caractérisés en ce que, indépendamment les uns des autres, les symboles R, $R^2$, $R^4$ et $R^6$ représentent, à titre de restes aliphatiques, un reste alkylène linéaire ou ramifié (pouvant être interrompu par des atomes d'oxygène, par NH, $NR^8$ ou $^+NR^8_2G^-$, où $R^8$ représente un groupe alkyle ayant 1 à 10 atomes de carbone ou cycloalkyle ayant 5 ou 6 atomes de carbone cycliques, un groupe phényle ou benzyle, et $G^-$ représente l'anion d'un acide protonique, un groupe cyclohexylène, naphtylène, phénylène ou hydantoïne) ; à titre de restes cycloaliphatiques, ils représentent un groupe cycloalkylène monocyclique ou bicyclique ayant 5 à 7 atomes de carbone cycliques, non substitués ou substitués par un groupe alkyle ; à titre de restes araliphatiques, ils représentent un reste aralkylène non substitué ou substitué sur le fragment aryle par un groupe alkyle, le reste alkylène pouvant être linéaire ou ramifié ; et, à titre de restes aromatiques, ils représentent un reste d'hydrocarbures ou un reste de pyridine, non substitués ou substitués par un groupe alkyle, alcoxy, alcoxyalkyle, triméthylène ou tétraméthylène.

10. Polycondensats selon la revendication 9, caractérisés en ce que les symboles R, $R^2$ $R^4$ et $R^6$ représentent, à titre de restes aliphatiques, un groupe alkylène linéaire ou ramifié ayant 2 à 30 atomes de carbone, $-(CH_2)_x-R^8-(CH_2)_y-$, où $R^8$ représente un groupe phénylène, naphtylène, cyclopentylène ou cyclohexylène, et x et y représentent, indépendamment l'un de l'autre, un nombre valant 1, 2 ou 3, un groupe $-R^9-(-OR^{10}-)_p-O-R^9$, où $R^9$ représente un groupe éthylene, propylène-1,2, propylène-1,3 ou méthyl-2 propylène-1,3 et $R^{10}$ représente un groupe éthylène, propylène-1,2, butylène-1,2, propylène-1,3 ou butylène-1,4, et p est un nombre valant 1 à 100, ou bien un groupe

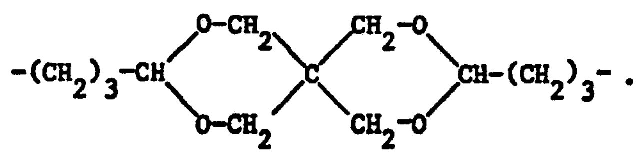 .

11. Polycondensats selon la revendication 9, caractérisés en ce que, à titre de reste cycloaliphatique, les restes R, $R^2$, $R^4$ et $R^6$ représentent ceux répondant aux formules :

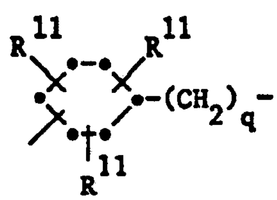

ou

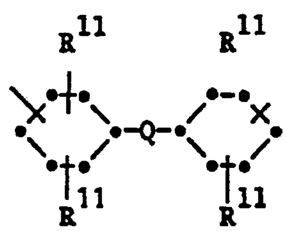

dans les quelles q est nul ou vaut 1, les $R^{11}$ représentent, indépendamment l'un de l'autre, un atome d'hydrogène ou un groupe alkyle ayant 1 à 6 atomes de carbone, et X représente une liaison directe, O, S, $SO_2$, un groupe alkylène ayant 1 à 3 atomes de carbone ou alkylidène ayant 2 à 6 atomes de carbone.

12. Polycondensats selon la revendication 9, caractérisés en ce que, à titre de restes aromatiques, les restes R, $R^2$, $R^4$ et $R^6$ sont substitués par un groupe alkyle, alcoxy ou alcoxyalkyle ayant 1 à 6 atomes de carbone, ou bien deux atomes de carbone voisins du reste aromatique sont substitués par un groupe triméthylène ou tétraméthylène.

13. Polycondensats selon la revendication 12, caractérisés en ce que, dans les formules I à IV, les symboles X et Y représentent le groupe $-NR^7-$, et l'un des substituants, ou les deux substituants, sont fixés en position ortho par rapport au groupe $-NR^7-$.

14. Polycondensats selon la revendication 9, caractérisés en ce que le reste araliphatique répond à la formule :

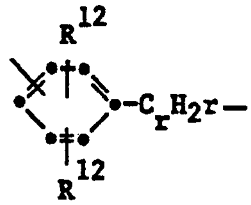

dans laquelle les $R^{12}$ représentent, indépendamment l'un de l'autre, un atome d'hydrogène ou un groupe alkyle ayant 1 à 6 atomes de carbone, et r représente les nombres entiers valant 1 à 16.

15. Polycondensats selon la revendication 14, caractérisés en ce que la liaison libre est en position para par rapport au groupe $C_rH_{2r}$, et l'un des $R^{12}$, ou les deux $R^{12}$, représentent chacun un groupe alkyle est ou sont en position ortho par rapport á la liaison libre.

16. Polycondensats selon la revendication 9, caractérisés en ce que le reste aromatique répond aux formules:

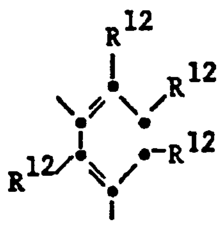 , 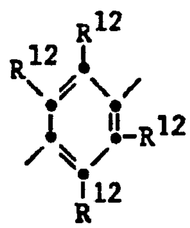 , 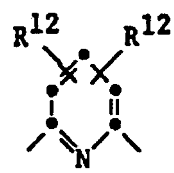 ,

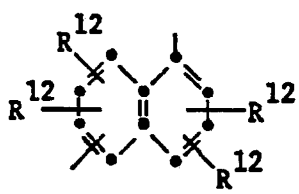 , 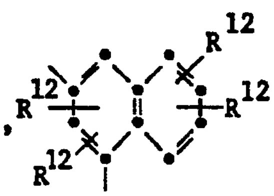 , 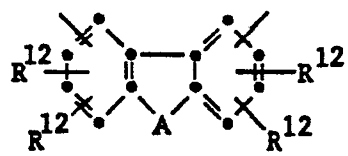

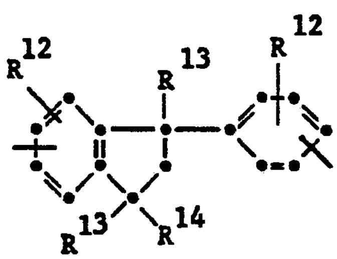 ou

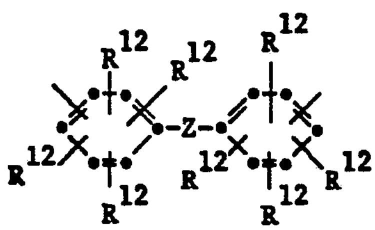

dans lesquelles $R^{12}$ représente un atome d'hydrogène ou bien, en cas de monosubstitution, un $R^{12}$ représente un groupe alkyle ayant 1 à 6 atomes de carbone et les autres $R^{12}$ représentent les atomes d'hydrogène et, en cas de disubstitution, de trisubstitution ou de tétrasubstitution, deux $R^{12}$ représentant les groupes alkyles ayant 1 à 6 atomes de carbone et les autres $R^{12}$ représentant chacun un atome d'hydrogène ou un groupe alkyle ayant 1 à 6 atomes de carbone ou, en cas de disubstitution, de trisubstitution ou de tétrasubstitution, deux $R^{12}$ vicinaux du noyau phényle

représentent un groupe triméthylène ou tétraméthylène et les autres $R^{12}$ représentent chacun un atome d'hydrogène ou un groupe alkyle ayant 1 à 6 atomes de carbone, A représente O, S, NH, CO ou $CH_2$, $R^{13}$ représente un atome d'hydrogène ou un groupe alkyle ayant 1 à 5 atomes de carbone et $R^{14}$ représente un groupe alkyle ayant 1 à 5 atomes de carbone, et Z représente une liaison directe, O, S, SO, $SO_2$, CO,

O O
|| ||
CO, $CNR^{15}$, $NR^{15}$, CONH, NH, $R^{15}SiO^{16}$, $R^{15}OSiOR^{16}$, un groupe alkylène ayant 1 à 6 atomes de carbone, alcénylène ou alkylidène ayant 2 à 6 atomes de carbone, phénylène ou phényldioxy, les symboles $R^{15}$ et $R^{16}$, représentant, indépendamment l'un de l'autre, chacun un groupe alkyle ayant 1 à 6 atomes de carbone ou un groupe phényle.

17. Polycondensats selon la revendication 16, caractérisés en ce que le reste aromatique est un reste :

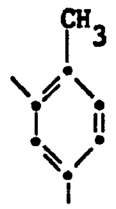 , 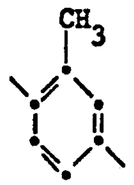 , 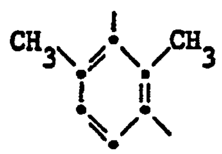 , 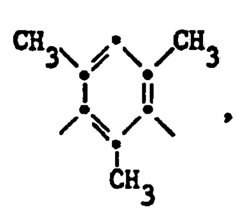 , 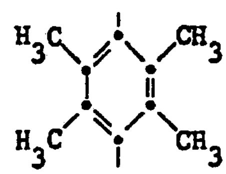 ,

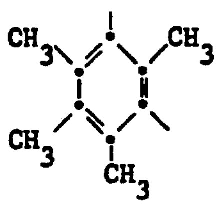 ou 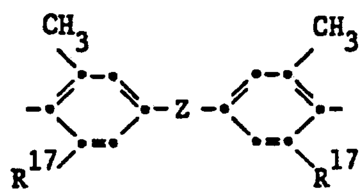

où Z représente une liaison directe, O et en particulier $CH_2$, et $R^{17}$ représente un atome d'hydrogène, un groupe méthyle ou éthyle.

18. Polycondensats selon la revendication 1, caractérisés en ce que X et Y, dans les formules (I) à (IV), représentent le groupe $-NR^7-$, et les symboles R, $R^2$, $R^4$ et $R^6$, représentent un reste selon la revendication 17, $R^{17}$ est un groupe méthyle ou éthyle, ou un groupe alkylène ramifié ayant 6 à 20 atomes de carbone qui est de préférence ramifié en position alpha par rapport au groupe $-NR^7-$.

19. Polycondensats selon la revendication 8, caractérisés en ce que, dans les formules (I) à (IV), les symboles X et Y représentent -O-, et les symboles R, $R^2$, $R^4$ et $R^6$ représentent un groupe alkylène ramifié, et en particulier linéaire, ayant 2 à 12 atomes de carbone.

20. Polycondensats selon la revendication 1, caractérisés en ce que, dans la formule (III), $R^3$ représente un groupe alkylène linéaire ou ramifié ayant 2 à 12 atomes de carbone, un groupe cycloalkylène ayant 5 à 7 atomes de carbone cycliques ou un reste d'hydrocarbure aromatique comportant 6 à 18 atomes de carbone.

21. Polycondensats selon la revendication 1, caractérisés en ce que, dans la formule (IV), $R^5$ représente un groupe phénotriyle-1,2,4.

22. Polycondensats selon la revendication 1, caractérisés en ce qu'ils contiennent les éléments structurels :

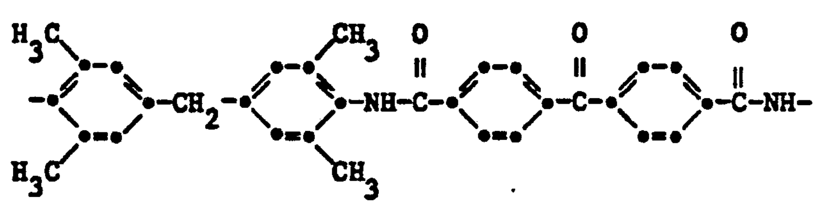 ou

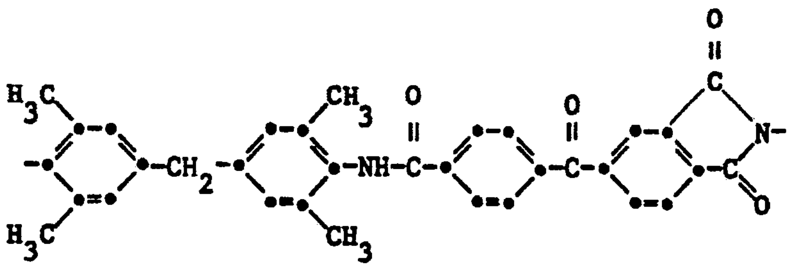 ou

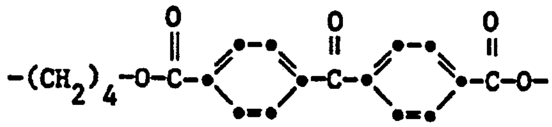

23. Procédé pour réparer des polycondensats selon la revendication 1, caractérisé en ce qu'on soumet de l'acide benzophénone-dicarboxylique de formule (V):

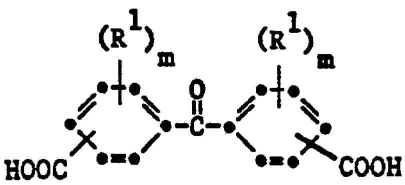 (V)

ou un acide benzophénone-tricarboxylique de formule (VI):

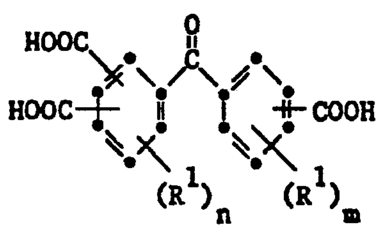 (VI)

ou des mélanges de ces acides, en une quantité d'au moins 2 moles-%, sur la base du polycondensat, éventuellement avec un acide dicarboxylique de formule (VII) et/ou un acide tricarboxylique de formule (VIII) :

$HOOC\text{-}R^3\text{-}COOH$ (VII)

```
HOOC
    \
     R⁵-COOH        (VIII)
    /
HOOC
```

ou leurs dérivés formateurs de polyesters ou de polyamides à une polycondensation avec un diol, un dimercaptan, une diamine, un amino-alcool, un aminomercaptan, un hydroxymercaptan de formule (IX) ou avec des mélanges de ces monomères :

HX - R - YH (IX),

les nombres m, et n et les symboles $R^1$, $R^3$, $R^5$ et $R^7$ ayant le sens indiqué, et X et Y représentant -O-, -S- ou $-NHR^7-$ ou bien X représente -O- ou -S- et Y représente $NHR^7$.

24. Matières revêtues, contenant sur un support une couche d'un polycondensat selon la revendication 1.

25. Utilisation de la matière selon la revendication 24 pour préparer des couches protectrices ou former des images photographiques par exposition, éventuellement à travers une photoréserve ou un photomasque puis enlèvement des parties non exposées du polycondensat.